# EUROPEAN PATENT SPECIFICATION

(11) **EP 3 432 460 B1**
(45) Date of publication and mention of the grant of the patent: **06.04.2022**
(21) Application number: 16894485.8
(22) Date of filing: 24.08.2016
(51) Int. Cl.: H02M 7/48, H02M 1/08, H02M 1/32, H03K 17/082, H03K 17/14, H03K 17/16

(54) **POWER CONVERTER**
STROMWANDLER
CONVERTISSEUR D'ÉNERGIE

(30) Priority: 16.03.2016 JP 2016052293
(43) Date of publication of application: 23.01.2019
(73) Proprietor: Mitsubishi Electric Corporation, Chiyoda-ku Tokyo 100-8310 (JP)
(72) Inventor: AMIMOTO, Takeshi, Tokyo 100-8310 (JP)
(74) Representative: Mewburn Ellis LLP
(86) International application number: PCT/JP2016/074630
(87) International publication number: WO 2017/158867

(56) References cited:
- JP-A- H0 779 568
- JP-A- 2003 088 098
- JP-A- 2003 088 098
- JP-A- 2008 136 326
- JP-A- 2015 033 222
- JP-A- 2015 033 222
- JP-A- 2016 197 956
- US-A1- 2016 173 094
- Texas Instruments: "Ringing Reduction Techniques for NexFET TM High Performance MOSFETs", Application Report SLPA010, 1 November 2011 (2011-11-01), XP055603191, Retrieved from the Internet: URL:http://citenpl.internal.epo.org/wf/web /citenpl/citenpl.html [retrieved on 2019-07-08]

## Description

### TECHNICAL FIELD

The present invention relates to a power converter.

### BACKGROUND ART

A power converter may be a DC/AC inverter converting DC power to AC power, an AC/DC converter converting AC power to DC power, or a DC/DC converter stepping up or stepping down a voltage value of DC power, for example. Most power converters use insulated gate semiconductor switching devices such as MOSFET (Metal-Oxide-Semiconductor Field-Effect Transistor) or IGBT (Insulated Gate Bipolar Transistor) for converting power. Herein, as to a semiconductor switching device which is a MOSFET, its drain electrode is called positive electrode, its source electrode is called negative electrode, and its gate electrode is called control electrode and, as to a semiconductor switching device which is an IGBT, its collector electrode is called positive electrode, its emitter electrode is called negative electrode, and its gate electrode is called control electrode.

In an insulated gate semiconductor switching device, turn-on and turn-off between the positive electrode and the negative electrode are controlled based on the magnitude of a drive voltage that is output from a drive circuit connected between the negative electrode and the control electrode. The drive circuit is connected to a drive power supply, and supplied with drive power from the drive power supply.

In a conventional power converter, series-connected semiconductor switching devices constitute an arm circuit made up of an upper arm and a lower arm, and three arm circuits are connected in parallel. Thus, a three-phase bridge circuit in which six semiconductor switching devices are used in total is formed to convert DC power to three-phase AC power. To each semiconductor switching device, a separate drive circuit is connected. Respective drive circuits for three semiconductor switching devices constituting the lower arms are connected to one drive power supply and supplied with electric power from the drive power supply. A power converter having such a configuration is known to have impedance means implemented as a resistor or diode between a reference potential terminal of each drive circuit and the negative terminal of the drive power supply, in order to prevent main circuit current flowing through one arm circuit from partially branching toward the drive circuit to flow into another arm circuit through the negative terminal of the drive power supply (see Patent Document 1, for example).

In the power converter disclosed in Patent Document 1, it is possible to prevent the main circuit current partially branching toward the drive circuit from flowing into the drive circuit for another arm circuit. Therefore, an induced voltage caused by the branching main circuit current flowing through a wire inductance is prevented from being superimposed on the control electrode of another arm circuit. In this way, a switching loss and/or a surge voltage occurring to the semiconductor switching device is prevented.

### CITATION LIST

### PATENT DOCUMENT

PTD 1: Japanese Patent Laying-Open No. 2015-33222

Document JP 2003 088098 A refers to a circuit for damping the gate voltage oscillations of the switch which occur due to the wiring inductance and the capacitance between the electrode and the PCB.

### SUMMARY OF INVENTION

### TECHNICAL PROBLEM

In the power converter disclosed in Patent Document 1, the semiconductor switching device of the upper arm and the semiconductor switching device of the lower arm that form the arm circuit may both be turned on due to a malfunction, resulting in arm short circuit. Some power converters have a protective function of detecting occurrence of arm short circuit to stop the switching operation of the semiconductor switching device upon occurrence of arm short circuit, in order to prevent large arm short circuit current from flowing to damage the semiconductor switching device.

In the event of arm short circuit, however, the voltage between the negative electrode and the positive electrode of the semiconductor switching device is sharply changed and, from this sharp change, oscillation of the voltage between the negative electrode and the positive electrode of the semiconductor switching device may be generated. Noise due to this voltage oscillation may affect the protective function or other control functions. A resultant problem is that such a voltage oscillation between the negative electrode and the positive electrode of the semiconductor switching device can occur not only in the event of arm short circuit but also in the event of a sharp change of the voltage between the negative electrode and the positive electrode of the semiconductor switching device.

The present invention has been made to solve the above-described problem. An object is to provide a power converter capable of suppressing occurrence of oscillation of the voltage between the negative electrode and the positive electrode of the semiconductor switching device when the voltage between the negative electrode and the positive electrode of the semiconductor switching device is sharply changed.

### SOLUTION TO PROBLEM

A power converter according to the present invention is provided in claim 1.

### ADVANTAGEOUS EFFECTS OF INVENTION

In the power converter of the present invention, the impedance element is disposed in the closed circuit through which drive current flows for turning on the semiconductor switching device, so as to increase the inductance of the closed circuit to thereby cause a change in the resonance frequency of the closed circuit from the resonance frequency of the closed circuit without the impedance element. It is therefore possible to suppress oscillation of the voltage between the negative electrode and the positive electrode of the semiconductor switching device when a sharp change of the voltage between the negative electrode and the positive electrode of the semiconductor switching device occurs.

### BRIEF DESCRIPTION OF DRAWINGS

Fig. 1 is a circuit diagram showing a configuration of a power converter in Embodiment 1 of the present invention.
Fig. 2 is a time chart showing an operation of the power converter in Embodiment 1 of the present invention.
Fig. 3 is a partial circuit diagram showing a partial configuration of the power converter in Embodiment 1 of the present invention.
Fig. 4 is a circuit diagram showing another configuration of the power converter in Embodiment 1 of the present invention.
Fig. 5 is a circuit diagram showing a configuration of a lower arm drive circuit in Embodiment 1 of the present invention.
Fig. 6 is a partial pattern diagram showing a part of a wiring pattern of the power converter in Embodiment 1 of the present invention.
Fig. 7 is a partial pattern diagram showing a part of a wiring pattern of the power converter having another configuration in Embodiment 1 of the present invention.
Fig. 8 shows respective waveforms of drain-source voltages of upper and lower arms, arm short circuit current, and a source voltage in the event of arm short circuit in a comparative example.
Fig. 9 is a diagram showing a behavior of resonant current flowing through a drive circuit in the event of arm short circuit in a power converter of a comparative example.
Fig. 10 is a diagram showing a behavior of another resonant current flowing through the drive circuit in the event of arm short circuit in the power converter of the comparative example.
Fig. 11 shows respective waveforms of drain-source voltages of upper and lower arms, arm short circuit current, and a source voltage in the event of arm short circuit in the power converter in Embodiment 1 of the present invention.
Fig. 12 is a diagram showing inductance values of impedance elements in the power converter and the results of determination of effects in Embodiment 1 of the present invention.
Fig. 13 is a circuit diagram showing a configuration of a power converter in Embodiment 2 of the present invention.
Fig. 14 is a partial pattern diagram showing a part of a wiring pattern of the power converter in Embodiment 2 of the present invention.
Fig. 15 is a partial pattern diagram showing a part of a wiring pattern of the power converter having another configuration in Embodiment 2 of the present invention.

### DESCRIPTION OF EMBODIMENTS

### Embodiment 1

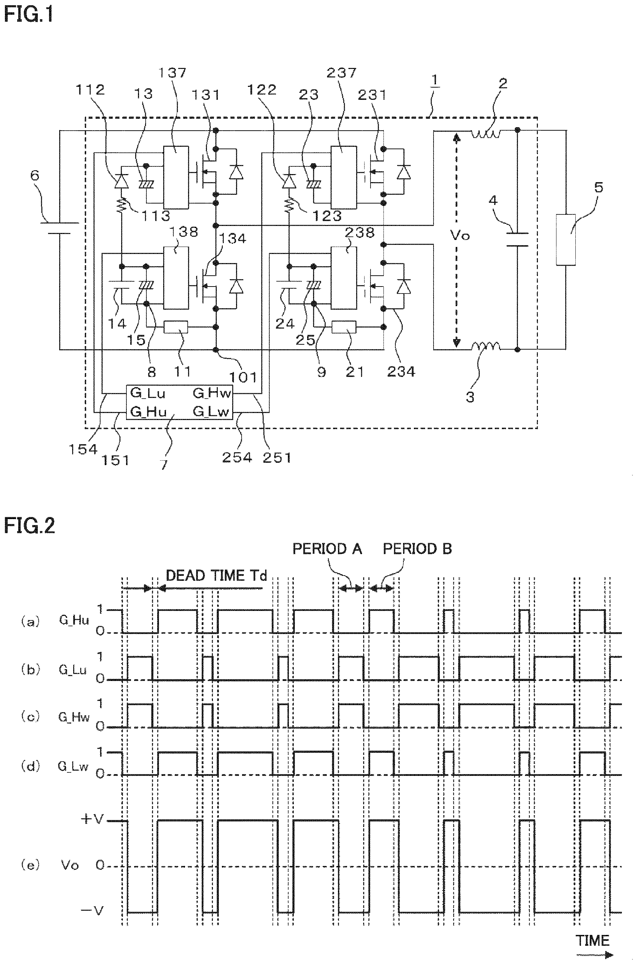

First, a configuration of a power converter in Embodiment 1 of the present invention is described. Fig. 1 is a circuit diagram showing the configuration of the power converter in Embodiment 1 of the present invention.

Referring to Fig. 1, power converter 1 is a single-phase inverter having an input terminal to which a DC power supply 6 is connected and an output terminal to which a load 5 is connected. Power converter 1 converts a DC voltage output from DC power supply 6 and input to the input terminal into a single-phase AC voltage to supply the AC voltage to load 5.

DC power supply 6 may be a DC/DC converter such as step-up converter or step-down converter stepping up or down a voltage of a DC power supply such as solar battery or any other battery to output the resultant voltage, or may be an AC/DC converter converting an AC voltage of an AC power supply such as system power supply to a DC voltage to output the DC voltage. DC power supply 6 may be placed within the same casing as power converter 1, or mounted on the same circuit board as power converter 1.

Load 5 may be a home electrical appliance or industrial electrical appliance caused to operate by a system supply voltage of 50 Hz or 60 Hz or by an AC voltage of 50 Hz or 60 Hz, may be a part mounted in a device such as a heating coil of an induction heating device caused to operate by an input AC voltage of a high frequency of several tens of kHz to several hundreds of kHz, a feeding coil of a wireless feeding device, or a primary coil of an isolation transformer for an isolation charger for electric vehicles, may be an electric motor of a moving body such as railroad vehicle or automobile, or may be an electric motor used for an elevator or escalator or industrial appliance, or may be a compressor of a refrigeration cycle device such as air conditioner or freezer. In connection with Embodiment 1, a description is given of a case where power converter 1 outputs an AC voltage of 50 Hz or 60 Hz.

As shown in Fig. 1, power converter 1 includes a full bridge circuit connected in parallel to DC power supply 6, a filter circuit connected to an output terminal of the full bridge circuit, and a control circuit controlling operation of the full bridge circuit.

The full bridge circuit includes a U phase arm circuit and a W phase arm circuit that are connected in parallel to each other. The U phase arm circuit includes a semiconductor switching device 131 and a semiconductor switching device 134 connected in series to each other. The W phase arm circuit includes a semiconductor switching device 231 and a semiconductor switching device 234 connected in series to each other. Of the semiconductor switching devices constituting the arm circuits of the present invention, the semiconductor switching devices connected to the positive terminal of DC power supply 6 are called upper arm and the semiconductor switching devices connected to the negative terminal of DC power supply 6 are called lower arm.

In the description of the present invention, the semiconductor switching device is a MOSFET. The semiconductor switching device, however, may be an IGBT. As shown in Fig. 1, the MOSFET has a body diode in the structure of the MOSFET. If the IGBT is used as the semiconductor switching device, a diode may be connected in parallel so as to conduct current in the opposite direction to a direction in which the IGBT conducts current. If the semiconductor switching device is a MOSFET, a diode may be further connected in parallel to the body diode. The semiconductor switching device may be a semiconductor switching device formed from a semiconductor material such as silicon (Si), silicon carbide (SiC), or gallium nitride (GaN), for example.

The semiconductor switching device of the present invention has a positive electrode, a negative electrode, and a control electrode that are defined in the following way. If the semiconductor switching device is a MOSFET, the drain electrode is defined as positive electrode, the source electrode is defined as negative electrode, and the gate electrode is defined as control electrode. If the semiconductor switching device is an IGBT, the collector electrode is defined as positive electrode, the emitter electrode is defined as negative electrode, and the gate electrode is defined as control electrode.

The filter circuit includes a filter reactor 2, a filter reactor 3, and a filter capacitor 4. Filter reactor 2 is connected to a connection point of semiconductor switching device 131 and semiconductor switching device 134, i.e., a midpoint of the U phase arm circuit serving as one output terminal of the full bridge circuit. Filter reactor 3 is connected to a connection point of semiconductor switching device 231 and semiconductor switching device 234, i.e., a midpoint of the W phase arm circuit serving as the other output terminal of the full bridge circuit. Filter capacitor 4 is connected between filter reactors 2, 3 and load 5.

The control circuit includes a controller 7 controlling switching of each semiconductor switching device, as well as a drive power supply and drive circuits for supplying drive power necessary for switching each semiconductor switching device. Controller 7 includes an arithmetic processor such as microcomputer, and a logic circuit, for example. The drive circuit is connected to each semiconductor switching device to output a drive voltage to the gate electrode of the semiconductor switching device based on a drive signal from controller 7. Each semiconductor switching device performs a switching operation based on the drive voltage. The control circuit has various sensors (not shown) each measuring voltage or current, for example of each part of power converter 1. Controller 7 has a control function for controlling the operation of power converter 1 based on results of measurement given from the sensors, and a protective function for stopping the operation of power converter 1 when a fault is detected.

The drive circuit is disposed for each semiconductor switching device. Upper arm drive circuits 137 and 237 are disposed for upper arm semiconductor switching devices 131 and 231, respectively. Lower arm drive circuits 138 and 238 are disposed for lower arm semiconductor switching devices 134 and 234, respectively.

The gate electrode and the source electrode of semiconductor switching device 131 of the upper arm of the U phase arm circuit are connected to upper arm drive circuit 137. To upper arm drive circuit 137, a smoothing capacitor 13 serving as a drive power supply is connected. The positive terminal of smoothing capacitor 13 is connected through a diode 112 and a current limiting resistor 113 to the positive terminal of a control power supply 14 to form a bootstrap circuit. Smoothing capacitor 13 is charged by the bootstrap circuit. The negative terminal of smoothing capacitor 13 and the source electrode of semiconductor switching device 131 are connected to each other in the inside of upper arm drive circuit 137. Alternatively, the negative terminal of smoothing capacitor 13 and the source electrode of semiconductor switching device 131 may be connected to each other in the outside of upper arm drive circuit 137. Upper arm drive circuit 137 is connected to controller 7 by a signal line 151. From controller 7, control signal G_Hu for controlling conducting (hereinafter called turn-on) and cutting off (hereinafter called turn-off) of semiconductor switching device 131 is output to upper arm drive circuit 137.

The gate electrode of semiconductor switching device 134 of the lower arm of the U phase arm circuit is connected to lower arm drive circuit 138. To lower arm drive circuit 138, a smoothing capacitor 15 serving as a drive power supply is connected. Control power supply 14 is connected in parallel to smoothing capacitor 15. Smoothing capacitor 15 is charged with electric power supplied from control power supply 14. The negative terminal of smoothing capacitor 15 serving as a drive power supply is connected to a reference potential connection point 8. To reference potential connection point 8, lower arm drive circuit 138 is connected. The lower arm drive circuit and reference potential connection point 8 are desirably connected to each other by a thick and short wire in order to make the wire impedance as low as possible. Reference potential connection point 8 is connected to the same potential as a reference potential of controller 7.

An impedance element 11 is connected between the source electrode of semiconductor switching device 134 of the lower arm and reference potential connection point 8. Impedance element 11 is a device for increasing the inductance of a closed circuit through which drive current flows for turning on semiconductor switching device 134. Impedance element 11 is preferably an inductor with a core such as ferrite core, or a coreless inductor without a core. Impedance element 11 is particularly preferably an inductor with a core. The inductor with a core is preferably a surface-mounted inductor such as ferrite bead inductor or chip inductor, or may be a winding-type inductor such as toroidal coil, or an inductor made of a tubular ferrite core and a lead passed through the ferrite core. The inductance may be increased by a ferrite core mounted on a wiring pattern on a circuit board, i.e., the wiring pattern on the circuit board may be used as a conductor of the inductor. Further, it may be a resistor having an inductance such as a wiring-type resistor.

Further, the source electrode of semiconductor switching device 134 is connected to a negative terminal connection point 101 to which the negative terminal of DC power supply 6 is connected. Lower arm drive circuit 138 is connected to controller 7 by a signal line 154. Control signal G_Lu is output from controller 7 to lower arm drive circuit 138 for controlling turn-on and turn-off of semiconductor switching device 134.

An insulated gate semiconductor switching device such as MOSFET has a parasitic capacitance between its gate electrode and its source electrode. As the parasitic capacitance is charged to cause the voltage between the gate electrode and the source electrode to reach a threshold voltage or higher that is necessary for the semiconductor switching device to be ON, the semiconductor switching device is turned on. When the charged parasitic capacitance is discharged to cause the voltage between the gate electrode and the source electrode to become less than the threshold voltage necessary for the semiconductor switching device to be ON, the semiconductor switching device is turned off.

For example, when semiconductor switching device 134 is to be turned on, a drive voltage is output from lower arm drive circuit 138 to the gate electrode of semiconductor switching device 134. At this time, drive current for turning on semiconductor switching device 134 flows in a closed circuit from the positive terminal of smoothing capacitor 15 serving as a drive power supply to the negative terminal of smoothing capacitor 15 through lower arm drive circuit 138, the gate electrode and the source electrode of semiconductor switching device 134, impedance element 11, and reference potential connection point 8. As a result, the parasitic capacitance between the gate electrode and the source electrode of semiconductor switching device 134 is charged to turn on semiconductor switching device 134. The drive current is also supplied from control power supply 14. However, because the internal resistance of smoothing capacitor 15 is lower than that of control power supply 14, the drive current is mainly supplied from smoothing capacitor 15. If smoothing capacitor 15 is not provided, control power supply 14 serves as a drive power supply.

When semiconductor switching device 134 is to be turned off, a voltage around 0 V is output from lower arm drive circuit 138 to the gate electrode of semiconductor switching device 134 to cause charge accumulated in the parasitic capacitance between the gate electrode and the source electrode of semiconductor switching device 134 to be discharged. The discharge current at this time flows in a closed circuit from the gate electrode of semiconductor switching device 134 to the source electrode of semiconductor switching device 134 through lower arm drive circuit 138, reference potential connection point 8, and impedance element 11.

The W phase arm circuit is configured similarly to the U phase arm circuit. Specifically, the gate electrode and the source electrode of upper arm semiconductor switching device 231 are connected to an upper arm drive circuit 237. To upper arm drive circuit 237, a smoothing capacitor 23 is connected. Smoothing capacitor 23 is charged by a bootstrap circuit made up of a diode 122 and a current limiting resistor 123 and electric power is supplied from smoothing capacitor 23 to upper arm drive circuit 237. Upper arm drive circuit 237 and controller 7 are connected to each other by a signal line 251, and control signal G_Hw is output from controller 7 to upper arm drive circuit 237 for controlling turn-on and turn-off of semiconductor switching device 231.

Moreover, the gate electrode of lower arm semiconductor switching device 234 of the W phase arm circuit is connected to a lower arm drive circuit 238. A smoothing capacitor 25 serving as a drive power supply is connected to lower arm drive circuit 238. Lower arm drive circuit 238 is connected to a reference potential connection point 9 to which the negative terminal of smoothing capacitor 25 serving as a drive power supply is connected. Further, a control power supply 24 is connected in parallel to smoothing capacitor 25. Smoothing capacitor 25 is charged with electric power supplied from control power supply 24. Between the source electrode of semiconductor switching device 234 and reference potential connection point 9, an impedance element 21 is connected. The source electrode of semiconductor switching device 234 is connected to a negative terminal connection point 101 to which the negative terminal of DC power supply 6 is connected. Impedance element 21 is configured similarly to U phase impedance element 11. Lower arm drive circuit 238 is connected to controller 7 by a signal line 254. Control signal G_Lw is output from controller 7 to lower arm drive circuit 238 for controlling turn-on and turn-off of semiconductor switching device 234.

Next, an operation of power converter 1 is described.

Fig. 2 is a time chart showing an operation of the power converter in Embodiment 1 of the present invention. Referring to Fig. 2, waveforms (a), (b), (c), and (d) are respective waveforms of control signals G_Hu, G_Lu, G_Hw, and G_Lw that are output from controller 7. The signals turning on the semiconductor switching devices are indicated by "1" and the signals turning off the semiconductor switching devices are indicated by "0." A waveform (e) is an output voltage waveform of the full bridge circuit shown in Fig. 1, and this voltage is a voltage at the midpoint of the U phase arm circuit with respect to the midpoint of the W phase arm circuit, where V is the voltage of DC power supply 6.

As shown in Fig. 2, control signal G_Hu for upper arm semiconductor switching device 131 of the U phase arm circuit and control signal G_Lu for lower arm semiconductor switching device 134 thereof that are output from controller 7 are both OFF during the period of dead time Td, and alternately turned on/off in the period except for the period of dead time Td. Likewise, control signal G_Hw for upper arm semiconductor switching device 231 of the W phase arm circuit and control signal G_Lw for lower arm semiconductor switching device 234 thereof are both OFF during the period of dead time Td, and alternately turned on/off in the period except for the period of dead time Td.

In Period A, controller 7 outputs to U phase upper arm drive circuit 137 the control signal for turning off semiconductor switching device 131, and outputs to U phase lower arm drive circuit 138 the control signal for turning on semiconductor switching device 134. As a result, the midpoint of the U phase arm circuit is connected to the negative terminal of DC power supply 6 to become the potential of DC power supply 6. In Period A, controller 7 outputs to W phase upper arm drive circuit 237 the control signal for turning on semiconductor switching device 231, and outputs to W phase lower arm drive circuit 238 the control signal for turning off semiconductor switching device 234. As a result, the midpoint of the W phase arm circuit is connected to the positive terminal of DC power supply 6 to become the potential of the positive terminal of DC power supply 6. Accordingly, as shown by (e) in Fig. 2, output voltage Vo of the full bridge circuit is -V.

Likewise, in Period B, upper arm semiconductor switching device 131 of the U phase arm circuit is ON and lower arm semiconductor switching device 234 of the W phase arm circuit is ON. Accordingly, output voltage Vo of the full bridge circuit is +V.

When output voltage Vo of the full bridge circuit is -V, the main circuit current that is output from DC power supply 6 flows through upper arm semiconductor switching device 231 of the W phase arm circuit and through lower arm semiconductor switching device 134 of the U phase arm circuit. When output voltage Vo of the full bridge circuit is +V, the main circuit current flows through upper arm semiconductor switching device 131 of the U phase arm circuit and through lower arm semiconductor switching device 234 of the W phase arm circuit.

As shown in Fig. 2, the ratio between the ON time and the OFF time of each semiconductor switching device of the U phase arm circuit and the W phase arm circuit is modified so that voltage waveform Vo as indicated by (e) in Fig. 2 is output from the midpoint of each arm circuit. As voltage waveform Vo indicated by (e) in Fig. 2 is passed through the filter circuit, a sinusoidal voltage is applied to load 5.

If the upper arm semiconductor switching device and the lower arm semiconductor switching device of the arm circuit are turned on simultaneously resulting in arm short circuit in the event of a malfunction due to influence of noise for example, controller 7 detects the arm short circuit current based on the result of measurement by a current sensor for example to output the control signal for turning off all the semiconductor switching devices. As a result, the operation of power converter 1 is stopped.

Next, functions and effects of power converter 1 of the present invention are described.

Arm short circuit occurs when noise generated from power converter 1 or noise generated outside power converter 1 is superimposed on any control signal which is output from controller 7 or any drive voltage which is output from upper arm drive circuit 137, 237 or lower arm drive circuit 138, 238 to erroneously cause the semiconductor switching device in its OFF period to be turned on.

Occurrence of the arm short circuit causes oscillation of the drain-source voltage of the semiconductor switching devices of the upper arm and the lower arm, and noise generated due to the oscillation of the drain-source voltage may hinder the protective function of the power converter from working properly. As shown in Fig. 1, power converter 1 of the present invention is provided with impedance elements 11 and 21 each having an inductance increasing the inductance of a path through which drive current flows for turning on lower arm semiconductor switching devices 134 and 234. It is therefore possible to suppress oscillation of the drain-source voltage in the event of arm short circuit, and thus suppress noise generated due to the oscillation of the drain-source voltage.

While details are given later herein, as arm short circuit occurs, the drain-source voltage of the semiconductor switching device is sharply changed. Specifically, a large dV/dt is generated. Due to this large dV/dt, resonant current resultant from series resonance of a parasitic capacitance between the gate electrode and the source electrode of the semiconductor switching device and the wire inductance of the drive circuit for the semiconductor switching device may flow through the drive circuit for the semiconductor switching device. The resonant current causes the parasitic capacitance between the gate electrode and the source electrode of the semiconductor switching device to be charged or discharged, and therefore, the electrical conductivity between the drain electrode and the source electrode varies at the resonance frequency, resulting in generation of oscillation of the drain-source voltage. Particularly when the component of the resonance frequency occupies a large proportion of the dV/dt frequency component in the event of arm short circuit, the resonant current is larger to cause a problem that the oscillation of the drain-source voltage is conspicuous.

As shown in Fig. 1, according to Embodiment 1, respective closed circuits through which drive current flows for turning on lower arm semiconductor switching devices 134 and 234 are provided with impedance elements 11 and 21, respectively. In this way, the inductance of each closed circuit is increased, and the resonance frequency of the closed circuit can be changed toward the low frequency side as compared with the resonance frequency of the closed circuit without impedance element. As a result, the frequency component occupying a large proportion of dV/dt in the event of arm short circuit can be shifted from the resonance frequency of the closed circuit through which drive current flows. The resonant current can be suppressed, and accordingly the oscillation of the drain-source voltage can be suppressed.

In particular, when an inductor having a core is used as the impedance element, the inductor has a frequency characteristic that the resistance component increases with increase of the frequency. Therefore, in addition to the effect that the frequency component occupying a large proportion of dV/dt in the event of arm short circuit can be shifted from the resonance frequency of the closed circuit through which drive current flows, the effect that it is possible to suppress current resultant from arm short circuit in which a larger proportion is high frequency components as compared with drive circuit generated in normal switching operation. Thus, the impedance element is particularly preferably an inductor having a characteristic that the resistance component increases with increase of the frequency.

As a result, the protective function of power converter 1 works properly, and the operation of power converter 1 can be stopped upon occurrence of arm short circuit. Moreover, not only the protective function but also other control function can work properly.

Reference potential connection point 8 to which lower arm drive circuit 138 is connected and reference potential connection point 9 to which lower arm drive circuit 238 is connected are connected to the same potential as the reference potential of controller 7. Therefore, noise due to oscillation of the drain-source voltage in the event of arm short circuit is easily propagated from the drive circuit for the lower arm semiconductor switching device to controller 7 or other parts of the control circuit.

In view of the above, respective closed circuits through which drive current flows for turning on lower arm semiconductor switching devices 134 and 234 are provided with impedance elements 11 and 21 respectively as described above in connection with Embodiment 1. Accordingly, as compared with the case where closed circuits in which drive current flows for turning on upper arm semiconductor switching devices 131 and 231 are provided with impedance elements, the effect of suppressing influence of noise generated due to arm short circuit on controller 7 or other component of the control circuit can be made larger. Not only the lower arm but also the upper arm may be provided with impedance elements.

As shown in Fig. 1, impedance element 11 is disposed between reference potential connection point 8 and the source electrode of lower arm semiconductor switching device 134, and impedance element 21 is disposed between reference potential connection point 9 and the source electrode of lower arm semiconductor switching device 234, from which the effect of suppressing arm short circuit of the U phase arm circuit and the W phase arm circuit is also derived. Regarding the effect that occurrence of arm short circuit is suppressed by the impedance element, a description is given of the case where U phase upper arm semiconductor switching device 131 in the ON state is turned off into the OFF state.

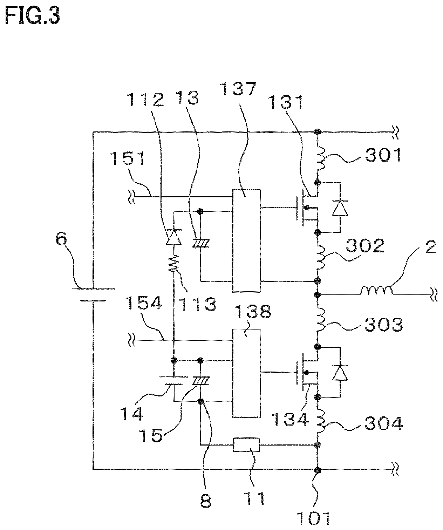

Fig. 3 is a partial circuit diagram showing a partial configuration of the power converter in Embodiment 1 of the present invention. Fig. 3 is the circuit diagram showing the U phase arm circuit and its periphery of power converter 1 shown in Fig. 1, to which wire inductances 301 to 304 are added.

Referring to Fig. 3, wire inductance 301 is included between the drain electrode of upper arm semiconductor switching device 131 of the U phase arm circuit and the positive terminal of DC power supply 6, and wire inductance 302 is included between the source electrode of semiconductor switching device 131 and the midpoint of the U phase arm circuit. Wire inductance 303 is included between the drain electrode of lower arm semiconductor switching device 134 of the U phase arm circuit and the midpoint of the U phase arm circuit, and wire inductance 304 is included between the source electrode of semiconductor switching device 134 and a connection point to which one end of impedance element 11 is connected. A filter reactor 2 is connected to the midpoint of the U phase arm circuit.

While upper arm semiconductor switching device 131 is ON, the main circuit current which is output from DC power supply 6 flows through upper arm semiconductor switching device 131 and then filter reactor 2 to load 5. When the ON period of upper arm semiconductor switching device 131 expires and a dead time period starts, upper arm semiconductor switching device 131 is turned off, while the current flowing through filter reactor 2 still flows. As a result, the current flowing through filter reactor 2 passes through the body diode of lower arm semiconductor switching device 134. The current flowing through the body diode of the lower arm flows through lower arm wire inductances 303, 304. Therefore, an induced voltage is generated across lower arm wire inductances 303, 304.

As to the induced voltage generated across wire inductance 304, the potential of the end connected to one end of impedance element 11 is positive with respect to the end connected to the source electrode of semiconductor switching device 134. If there is no impedance element 11, the positive potential with respect to the source electrode of semiconductor switching device 134 is directly used as a potential of reference potential connection point 8. Therefore, even when lower arm drive circuit 138 outputs a drive voltage around 0 V for turning off semiconductor switching device 134, a positive voltage is applied between the source electrode and the gate electrode of lower arm drive circuit 138. The time taken for current flowing through filter reactor 2 to be commutated from the upper arm to the lower arm of the U phase arm circuit is several micro seconds or shorter. If there is no impedance element 11, the voltage generated across wire inductance 304 may cause lower arm semiconductor switching device 134 to be turned on within the several micro seconds or shorter. When the current flowing through filter reactor 2 is commutated and upper arm semiconductor switching device 131 is not completely turned off, both upper arm semiconductor switching device 131 and lower arm semiconductor switching device 134 may be turned on to cause arm short circuit.

In contrast, according to the present invention as shown in Fig. 3, impedance element 11 is provided between reference potential connection point 8 and one end of wire inductance 304 connected to the source electrode of lower arm semiconductor switching device 134. Therefore, a part of the voltage generated across wire inductance 304 is applied to impedance element 11. The voltage between the source electrode of semiconductor switching device 134 and reference potential connection point 8 can thus be reduced. As a result, it is possible to reduce the possibility that lower arm semiconductor switching device 134 is erroneously turned on when current flowing through filter reactor 2 is commutated, and thus suppress occurrence of arm short circuit.

Next, a further detailed description is given of a power converter of the present invention, using a power converter in which each arm of a full bridge circuit includes a plurality of semiconductor switching devices connected in parallel.

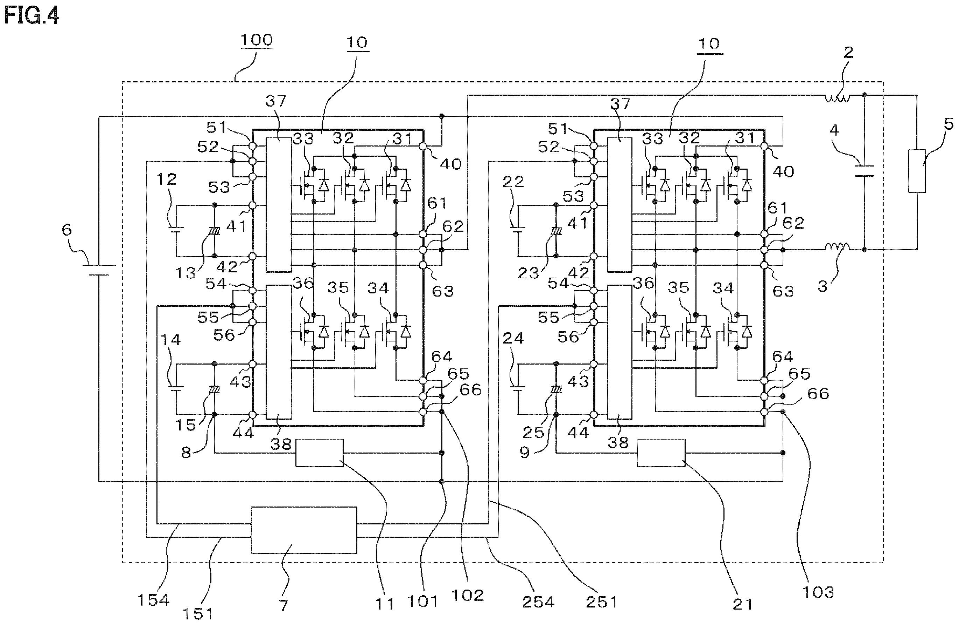

Fig. 4 is a circuit diagram showing another configuration of the power converter in Embodiment 1 of the present invention. In Fig. 4, any component denoted by the same reference numeral as Fig. 1 is the same or corresponding component, and the description thereof is not repeated herein. Power converter 100 in Fig. 4 differs from power converter 1 in Fig. 1 in that the U phase arm circuit and the W phase arm circuit are each implemented as a power module 10 in the former power converter. Power module 10 is made up of MOSFETs and each semiconductor switching device is formed from a silicon carbide semiconductor material (hereinafter referred to as SiC MOSFET).

As shown in Fig. 4, the U phase arm circuit and the W phase arm circuit of power converter 100 are each implemented as power module 10, and the U phase arm circuit and the W phase arm circuit constitute a full bridge circuit. Power module 10 includes therein three arm circuit sets that are an arm circuit including semiconductor switching device 31 and 34, an arm circuit including semiconductor switching devices 32 and 35, and an arm circuit including semiconductor switching devices 33 and 36, an upper arm drive circuit 37, and a lower arm drive circuit 38. U phase power module 10 and W phase power module 10 have the same configurations. Power module 10 mentioned as it is in Embodiment 1 refers to both U phase and W phase power modules 10. When the U phase and the W phase are to be distinguished from each other, the power modules are referred to as U phase power module 10 and W phase power module 10.

Power module 10 used in power converter 100 is not limited to the power module including therein three arm circuit sets, but may be a power module including at least one arm circuit set. Instead of the power module, discrete semiconductor switching devices may be used to form the power converter shown by the circuit diagram of Fig. 4. Regarding the present invention, "power module" and "discrete semiconductor switching device" mean a semiconductor device including a semiconductor chip in a casing made of resin or the like. A semiconductor device including therein one arm is called herein a discrete semiconductor switching device, and a semiconductor device including therein a plurality of arms is called power module.

As shown in Fig. 4, in power converter 100, lower arm semiconductor switching devices 134 and 234 of power converter 1 shown in Fig. 1 are each replaced with three semiconductor switching devices 34, 35, 36 connected in parallel, and upper arm semiconductor switching devices 131 and 231 thereof are each replaced with three semiconductor switching devices 31, 32, 33 connected in parallel.

Respective drain electrodes of upper arm semiconductor switching devices 31, 32, 33 arranged in power module 10 are connected to a high-voltage input terminal 40 of power module 10, and high-voltage input terminal 40 is connected to the positive terminal of DC power supply 6. Respective source electrodes of upper arm semiconductor switching devices 31, 32, 33 are connected individually to upper arm drive circuit 37, and respective gate electrodes of upper arm semiconductor switching devices 31, 32, 33 are connected individually to upper arm drive circuit 37.

Respective source electrodes of lower arm semiconductor switching devices 34, 35, 36 are connected respectively to low-voltage input terminals 64, 65, 66 of power module 10. Low-voltage input terminals 64, 65, 66 of U phase power module 10 are connected to a single point at a negative electrode connection point 102, and low-voltage input terminals 64, 65, 66 of W phase power module 10 are connected to a single point at negative electrode connection point 103. Negative electrode connection points 102 and 103 are arranged outside power modules 10 to be connected to a negative terminal connection point 101 to which the negative terminal of DC power supply 6 is connected. Respective gate electrodes of lower arm semiconductor switching devices 34, 35, 36 are connected to lower arm drive circuit 38.

Negative terminal connection point 101, negative electrode connection point 102, and negative electrode connection point 103 may be a sheet-shaped or strip-shaped wiring pattern on a circuit board, and are each formed by a wiring pattern connected to the same potential.

Respective midpoints of the arm circuits in power module 10 are connected to respective output terminals 61, 62, 63, and output terminals 61, 62, 63 are connected to a single point outside power module 10 to be connected to a filter circuit.

Power module 10 includes a positive drive power supply terminal 43 and a negative drive power supply terminal 44 for supplying drive power to lower arm drive circuit 38 in power module 10. To positive drive terminal 43, respective positive terminals of smoothing capacitors 15 and 25 each serving as a drive power supply are connected. To negative drive power supply terminal 44, respective negative terminals of smoothing capacitors 15 and 25 are connected. Like power converter 1 in Fig. 1, the negative terminal of smoothing capacitor 15 is connected to reference potential connection point 8, and the negative terminal of smoothing capacitor 25 is connected to reference potential connection point 9.

Power module 10 includes a positive drive power supply terminal 41 and a negative drive power supply terminal 42 for supplying drive power to upper arm drive circuit 37 in power module 10. To positive drive terminal 41, respective positive terminals of smoothing capacitors 13 and 23 each serving as a drive power supply are connected. Respective negative terminals of smoothing capacitors 13 and 23 are connected to negative drive power supply terminal 42. Further, a control power supply 12 for charging smoothing capacitor 13 is connected in parallel to smoothing capacitor 13, and a control power supply 22 for charging smoothing capacitor 23 is connected in parallel to smoothing capacitor 23.

In Fig. 4, control power supplies 12 and 22 are each provided in order to supply drive power to upper arm drive circuit 37. However, a drive power may be supplied to upper arm drive circuit 37 by a bootstrap circuit as shown in Fig. 1. In Fig. 4, power module 10 in which a single positive drive power supply terminal 41 and a single negative drive power supply terminal 42 supplying drive power for the upper arm are provided for all the arm circuits is used. Alternatively, a power module in which a positive drive power supply and a negative drive power supply are provided for each upper arm may be used.

An impedance element 11 is connected between negative electrode connection point 102 and reference potential connection point 8 of the U phase, and an impedance element 21 is connected between negative electrode connection point 103 and reference potential connection point 9 of the W phase. Impedance elements 11 and 21 are each an impedance element having an inductance increasing the inductance of a closed circuit through which drive current flows for turning on lower arm semiconductor switching devices 34, 35, 36, like power converter 1 shown in Fig. 1.

Control signal input terminals 51, 52, 53 for applying a control signal to upper arm drive circuit 37 of power module 10 are connected to each other to be short-circuited in the outside of power module 10, and connected by signal lines 151 and 251 to controller 7. Likewise, control signal input terminals 54, 55, 56 for applying a control signal to lower arm drive circuit 38 of power module 10 are connected to each other to be short-circuited in the outside of power module 10, and connected by signal lines 154 and 254 to controller 7.

Accordingly, the same control signal is applied to upper arm semiconductor switching devices 31, 32, 33 of U phase power module 10, and semiconductor switching devices 31, 32, 33 of power module 10 are driven to have a period in which they are all ON, i.e., driven in parallel, even when there is some difference among the devices. Likewise, the same control signal is applied to lower arm semiconductor switching devices 34, 35, 36 of U phase power module 10, and semiconductor switching devices 34, 35, 36 of power module 10 are driven in parallel to have a period in which they are all ON, even when there is some difference among the devices. The same is applied to the semiconductor switching devices of W phase power module 10.

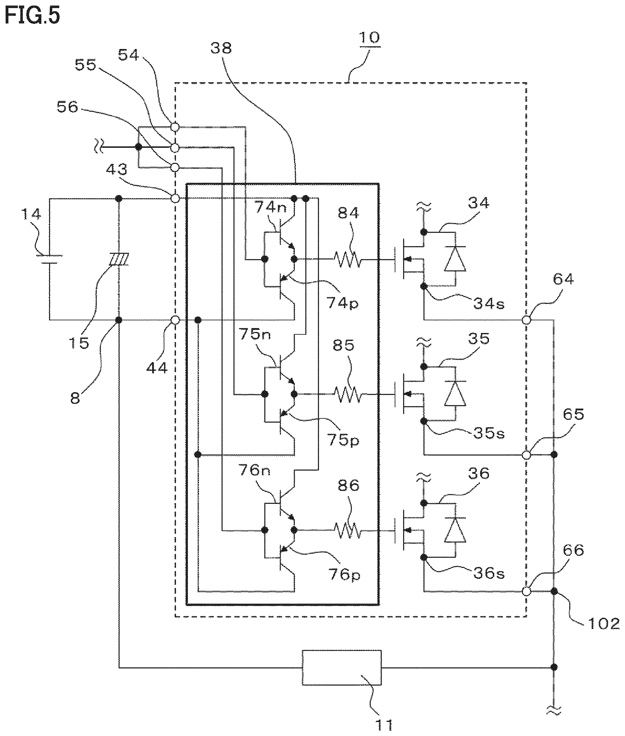

Next, a configuration of the lower arm drive circuit is described in further detail. Fig. 5 is a circuit diagram showing the configuration of the lower arm drive circuit in Embodiment 1 of the present invention. Fig. 5 shows, in addition to lower arm drive circuit 38, a part of the configuration of power converter 100. Upper arm drive circuit 37 may have a similar configuration to that of lower arm drive circuit 38 shown in Fig. 5.

Lower arm drive circuit 38 is constituted of NPN transistors 74n, 75n, 76n, PNP transistors 74p, 75p, 76p, and gate resistors 84, 85, 86. Lower arm drive circuit 38 shown in Fig. 5 includes three gate circuits each constituted of one NPN transistor, one PNP transistor, and one gate resistor. In other words, lower arm drive circuit 38 has the same number of gate circuits as the number of semiconductor switching devices connected to lower arm drive circuit 38. The gate circuit is not limited to this, but may be a gate circuit having another configuration such as a gate circuit formed of a gate drive integrated circuit. The drive circuit of the present invention is defined as a circuit including at least one gate circuit that outputs a drive voltage to the gate electrode of a semiconductor switching device.

In the gate circuit constituted of NPN transistor 74n, PNP transistor 74p, and gate resistor 84, the emitter electrode of NPN transistor 74n and the emitter electrode of PNP transistor 74p are connected to each other to form a midpoint, one end of gate resistor 84 is connected to this midpoint, and the base electrode of NPN transistor 74n and the base electrode of PNP transistor 74p are connected to each other. Other gate circuits are configured similarly to the above-described gate circuit.

Respective collector electrodes of NPN transistors 74n, 75n, 76n of respective gate circuits are connected to the positive terminal of smoothing capacitor 15 serving as a drive power supply, and respective collector electrodes of PNP transistors 74p, 75p, 76p of respective gate circuits are connected to reference potential connection point 8 to which the negative terminal of smoothing capacitor 15 is connected. Namely, the gate circuits are connected in parallel.

Respective base electrodes of NPN transistor 74n and PNP transistor 74p are connected to control signal input terminal 54, and the other end of gate resistor 84 is connected to the gate electrode of semiconductor switching device 34. Other gate circuits are configured similarly.

Low-voltage input terminals 64, 65, 66 to which source electrodes 34s, 35s, 36s of semiconductor switching devices 34, 35, 36 are connected are connected to negative electrode connection point 102 in the outside of power module 10, and impedance element 11 is connected between negative electrode connection point 102 and reference potential connection point 8. Namely, impedance element 11 is disposed in the outside of power module 10. As a result, the inductance of impedance element 11 can be adjusted freely depending on the inductance of the wiring pattern for the circuit board of power converter 100.

As a signal for turning on semiconductor switching device 34 is input to control signal input terminal 54, NPN transistor 74n is turned on and PNP transistor 74p is turned off. As a result, the gate electrode of semiconductor switching device 34 is electrically connected, through gate resistor 84, to positive drive power supply terminal 43 connected to the positive terminal of smoothing capacitor 15 serving as a drive power supply. Because the source electrode of semiconductor switching device 34 is connected to reference potential connection point 8 via impedance element 11, a voltage close to the voltage across smoothing capacitor 15 is applied between the source electrode and the gate electrode of semiconductor switching device 34.

As a result, drive current for turning on semiconductor switching device 34 flows through a closed circuit from the positive terminal of smoothing capacitor 15 serving as a drive power supply back to the negative terminal of smoothing capacitor 15, through the collector electrode of NPN transistor 74n, the emitter electrode of NPN transistor 74n, and gate resistor 84 that constitute the gate circuit, and through the gate electrode and source electrode 34s of semiconductor switching device 34, low-voltage input terminal 64, negative electrode connection point 102, impedance element 11, and reference potential connection point 8. Accordingly, the drive current charges the parasitic capacitance between the gate electrode and the source electrode of semiconductor switching device 34 to turn on semiconductor switching device 34.

In contrast, as a signal for turning off semiconductor switching device 34 is input to control signal input terminal 54, NPN transistor 74n is turned off and PNP transistor 74p is turned on. As a result, the gate electrode of semiconductor switching device 34 is connected to reference potential connection point 8 through gate resistor 84. As a result, the charge accumulated on the parasitic capacitance between the gate electrode and the source electrode of semiconductor switching device 34 is discharged through a closed circuit from the gate electrode of semiconductor switching device 34 back to the source electrode of semiconductor switching device 34 through gate resistor 84, PNP transistor 74p, negative drive power supply terminal 44, reference potential connection point 8, impedance element 11, and negative electrode connection point 102. Accordingly, semiconductor switching device 34 is turned off.

When semiconductor switching device 34 is to be turned on, drive current which is output from the positive terminal of smoothing capacitor 15 serving as a drive power supply may pass through low-voltage input terminal 64 and then partially branch off from low-voltage input terminal 65 toward source electrode 35s of semiconductor switching device 35, for example. The branching current may flow to the negative terminal of smoothing capacitor 15 through source electrode 35s and the gate electrode of semiconductor switching device 35, gate resistor 85, PNP transistor 75p, and reference potential connection point 8. In other words, a part of the drive current may also flow in a closed circuit different from the above-described closed circuit. While the branching current is a part of the drive current which is output from the positive terminal of smoothing capacitor 15, the branching current is extremely small because of a large impedance of the path. With this branching current only, the parasitic capacitance between the gate electrode and the source electrode of semiconductor switching device 34 cannot be charged to the extent that causes semiconductor switching device 34 to be turned on. Such branching current is therefore not called drive current for turning on a semiconductor switching device. The same is applied as well to current flowing in other branching paths.

Accordingly, a closed circuit through which drive current flows for turning on semiconductor switching device 34 of the present invention is defined as a closed circuit from the positive terminal of smoothing capacitor 15 to the negative terminal of smoothing capacitor 15 through lower arm drive circuit 38, the gate electrode and source electrode 34s of semiconductor switching device 34, negative electrode connection point 102, impedance element 11, and reference potential connection point 8. Semiconductor switching devices 35, 36 are similar to semiconductor switching device 34.

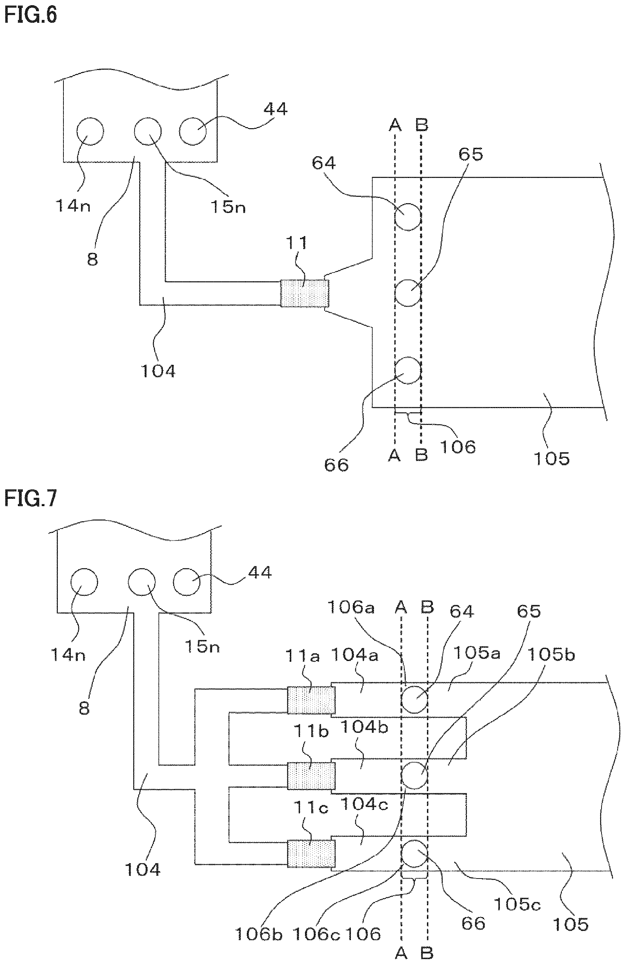

Fig. 6 is a partial pattern diagram showing a part of a wiring pattern of the power converter in Embodiment 1 of the present invention. Fig. 7 is also a partial pattern diagram showing a part of a wiring pattern of the power converter having another configuration in Embodiment 1 of the present invention. The wiring patterns in Figs. 6 and 7 each show the wiring pattern between low-voltage input terminals 64, 65, 66 and negative drive power supply terminal 44 and their periphery of power module 10 in power converter 100 shown in Fig. 4.

As shown in Fig. 6, low-voltage input terminals 64, 65, 66 connected to respective source electrodes of lower arm semiconductor switching devices in power module 10 are connected to the wiring pattern by soldering or the like. The portion to which low-voltage input terminals 64, 65, 66 are connected forms a planer wiring pattern and forms a negative electrode connection point.

In the wiring pattern shown in Fig. 6, a region on the left side of broken line A-A, a region on the right side of broken line B-B, and a region between broken line A-A and broken line B-B are defined, as seen on the drawing. The region on the left side of broken line A-A as seen on the drawing is a circuit line in which drive current flows for driving semiconductor switching devices, and the region on the left side of broken line A-A is called drive circuit line 104. The region on the right side of broken line B-B as seen on the drawing is a circuit line in which main circuit current flows between the drain electrode and the source electrode of a semiconductor switching device and back to the negative terminal of DC power supply 6 through negative terminal connection point 101 connected to the negative terminal of DC power supply 6, and the circuit line on the right side of broken line B-B is called main circuit line 105. The region between broken line A-A and broken line B-B is a negative electrode connection point and also a circuit line in which the drive current and the main circuit current flow. The drive current and the main circuit current also flow in a circuit line between respective source electrodes of semiconductor switching devices 34, 35, 36 and low-voltage input terminals 64, 65, 66. Therefore, the circuit line between respective source electrodes of semiconductor switching devices 34, 35, 36 and low-voltage input terminals 64, 65, 66 and the circuit line between broken line A-A and broken line B-B in Fig. 6 are collectively called common line. The circuit line between broken line A-A and broken line B-B in Fig. 6 is a part of the common line and called common line 106 herein.

One end of drive circuit line 104 is connected to reference potential connection point 8 formed by the planar-shaped wiring pattern. To reference potential connection point 8, negative drive power supply terminal 44 of power module 10 is connected by soldering or the like. A negative terminal 15n of smoothing capacitor 15 is connected in the vicinity of negative drive power supply terminal 44 by soldering or the like. A negative terminal 14n of control power supply 14 may be connected to the same planer wiring pattern as reference potential connection point 8 by soldering or the like.

As shown in Fig. 6, impedance element 11 is disposed on drive circuit line 104 between reference potential connection point 8 and the negative electrode connection point at which respective source electrodes of a plurality of parallel-connected semiconductor switching devices are connected together, so as to increase the inductance of the closed circuit through which drive current flows for turning on the semiconductor switching devices. Thus, the wiring pattern once connects, at the negative electrode connection point, respective source electrodes of a plurality of semiconductor switching devices that are driven in parallel, to thereby enable reduction of the influence of difference in length and/or thickness of the wire, among a plurality of semiconductor switching devices driven in parallel. In other words, the impedance of main circuit line 105 can be made common to the semiconductor switching devices, and therefore, even when a plurality of semiconductor switching devices are connected in parallel and driven in parallel, difference among the semiconductor switching devices in terms of the main circuit current flowing between the drain electrode and the source electrode of the semiconductor switching device can be reduced, which allows larger main circuit current to flow in the whole arm circuit.

When a plurality of semiconductor switching devices are connected in parallel and driven in parallel, the wiring pattern shown in Fig. 6 is preferred, however, the wiring pattern shown in Fig. 7 may also be used.

In the wiring pattern shown in Fig. 7, like the wiring pattern in Fig. 6, a region on the left side of broken line A-A is a drive circuit line 104, a region on the right side of broken line B-B is a main circuit line 105, and a region between broken line A-A and broken line B-B is respective parts of common lines, i.e., a common line 106, as seen on the drawing. Low-voltage input terminals 64, 65, 66 of power module 10 are connected to separate common lines 106a, 106b, 106c, respectively, by soldering or the like, low-voltage input terminal 64 is connected to drive circuit line 104a, low-voltage input terminal 65 is connected to drive circuit line 104b, and low-voltage input terminal 66 is connected to drive circuit line 104c. Drive circuit lines 104a, 104b, 104c are connected to common drive circuit line 104 and then connected to reference potential connection point 8. Respective drive circuit lines 104a, 104b, 104c are provided with impedance elements 11a, 11b, 11c, respectively. Low-voltage input terminals 64, 65, 66 are connected to main circuit lines 105a, 105b, 105c, respectively, and then connected to common main circuit line 105.

The wiring pattern of power converter 100 in Embodiment 1 of the present invention is not limited to the wiring patterns shown in Figs. 6 and 7, but may be a wiring pattern configured in a different manner.

Next, functions and effects of power converter 100 of the present invention are described in further detail.

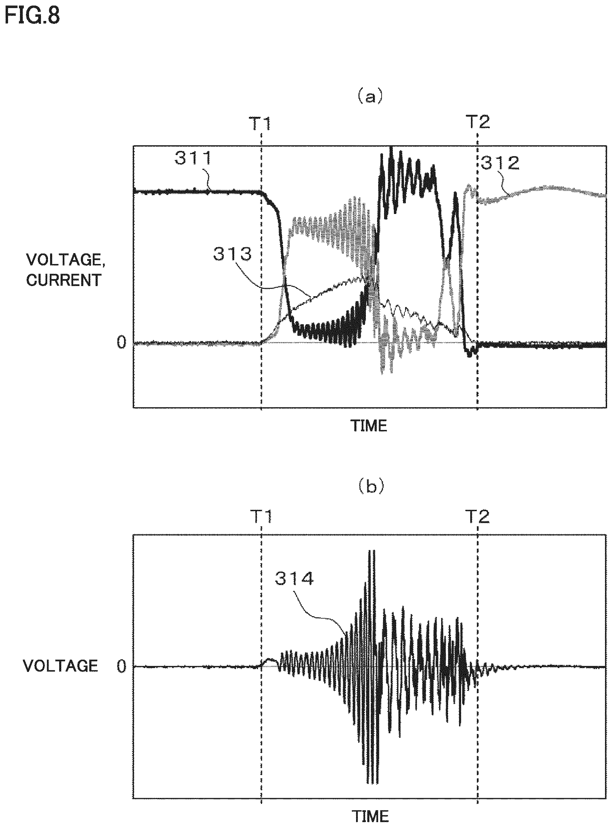

Fig. 8 shows waveforms of respective drain-source voltages of the upper arm and the lower arm, arm short-circuit current, and a source voltage in the event of arm short circuit in a comparative example. The waveforms in Fig. 8 are measured waveforms in the event of arm short circuit of power converter 100 shown in Fig. 4 in which impedance elements 11 and 21 are not included and negative electrode connection point 102 and reference potential connection point 8 are short-circuited and negative electrode connection point 103 and reference potential connection point 9 are short circuited, in the comparative example.

The horizontal axis of Fig. 8 (a) represents time, and the vertical axis thereof represents the magnitude of a drain-source voltage 311 of the upper arm and the magnitude of a drain-source voltage 312 of the lower arm, and the magnitude of arm short circuit current 313 flowing through the upper and lower arms that are short-circuited. The drain-source voltage of the upper arm is a measured voltage between high-voltage input terminal 40 of power module 10 of the U phase arm circuit and output terminals 61, 62, 63 thereof that are short-circuited. The drain-source voltage of the lower arm is a measured voltage between negative electrode connection point 102 and output terminals 61, 62, 63 that are short-circuited of power module 10 of the U phase arm circuit.

The horizontal axis of Fig. 8 (b) represents time, and the vertical axis thereof represents a source voltage 314 that is a voltage at negative electrode connection point 102 with respect to reference potential connection point 8. When the measurements in Fig. 8 (b) are taken, impedance element 11 is not provided as described above, and reference potential connection point 8 and negative electrode connection point 102 are connected together by a wire.

As shown in Fig. 8 (a), in the period from time T1 to time T2 in which the upper arm semiconductor switching device is switched from OFF to ON and the lower arm semiconductor switching device is switched from ON to OFF, arm short circuit occurs to cause arm short circuit current 313 to flow. In the period from time T1 to time T2 in which arm short circuit occurs, occurrence of oscillation of about 30 MHz can be confirmed on drain-source voltage 311 of the upper arm and drain-source voltage 312 of the lower arm. The influence of this oscillation is exhibited as oscillation of arm short circuit current 313.

As shown in Fig. 8 (b), in the period from time T1 to time T2 in which arm short circuit occurs, oscillation of about 30 MHz is also identified on source voltage 314 that is a voltage at negative electrode connection point 102 with respect to reference potential connection point 8. This oscillation of source voltage 314 is a voltage generated due to resonant current flowing through the impedance of the wire between negative electrode connection point 102 and reference potential connection point 8.

As mentioned above in the description of power converter 1 in Fig. 1, when arm short circuit occurs, resonant current flows through the closed circuit through which drive current flows for turning on the semiconductor switching device. This resonant current results from series resonance of a parasitic capacitance between the gate electrode and the source electrode of the semiconductor switching device and the inductance of the closed circuit through which drive current flows. Therefore, the parasitic capacitance between the gate electrode and the source electrode of the semiconductor switching device is charged/discharged at the same frequency as the resonant current. As a result, the electrical conductivity between the gate electrode and the source electrode of the semiconductor switching device varies at the resonance frequency to cause oscillation of the drain-source voltage.

If the semiconductor switching device is a MOSFET, the switching speed is higher than a semiconductor switching device which is an IGBT. Such a semiconductor switching device therefore responds to such high-frequency charging/discharging of the parasitic capacitance between the gate electrode and the source electrode, and thus oscillation of the voltage between the drain electrode and the source electrode is likely to occur. Further, as compared with a semiconductor switching device which is a MOSFET formed from a silicon semiconductor material, a semiconductor switching device which is an SiC MOSFET is used with a higher voltage and larger current, and thus large oscillation of the voltage between the positive electrode and the negative electrode is more likely to occur.

Therefore, the effect of the present invention of suppressing voltage oscillation between the positive electrode (drain electrode or collector electrode) and the negative electrode (source electrode or emitter electrode) that is generated when arm short circuit occurs, obtained by providing an impedance element in the closed circuit, is greater when the semiconductor switching device is a MOSFET as compared with a semiconductor switching device which is an IGBT, and this effect is much greater when the semiconductor switching device is a SiC MOSFET.

The power converter in which the waveforms in Fig. 8 are generated has a protective function of stopping operation of the power converter by turning off all the semiconductor switching devices, upon detecting arm short circuit current which flows when arm short circuit occurs. When the waveforms in Fig. 8 are generated, however, the protective function of the power converter does not properly work and operation of the power converter cannot be stopped by turning off all the semiconductor switching devices.

A reason why the protective function of the power converter does not work properly and operation of the power converter cannot be stopped by turning off all the semiconductor switching devices appears to be that noise generated due to oscillation of the drain-source voltage when arm short circuit occurs as shown in Fig. 8 (a) hinders the protective function from working properly. In view of this, as in power converter 100 of the present invention shown in Fig. 4, impedance element 11 is provided in the closed circuit through which drive current flows for turning on lower arm semiconductor switching devices of the U phase between reference potential connection point 8 and negative electrode connection point 102, and impedance element 21 is also provided in the closed circuit through which drive current flows for turning on the lower arm semiconductor switching devices of the W phase between reference potential connection point 9 and negative electrode connection point 103, so as to increase the inductance of these closed circuits. In this way, oscillation of the drain-source voltage occurring due to arm short circuit is suppressed to allow the protective function to work properly.

As shown in Fig. 4, when a plurality of semiconductor switching devices are connected in parallel and driven in parallel, difference among semiconductor switching devices increase the probability of occurrence of arm short circuit. The effect of preventing the protective function from not working properly by providing an impedance element to suppress oscillation of the drain-source voltage in the event of arm short circuit as described above in connection with the present invention is therefore significant.

As described above regarding power converter 1 shown in Fig. 1, impedance elements 11 and 21 can be disposed between reference potential connection points 8 and 9 and the source electrodes of the lower semiconductor switching devices to suppress a voltage increase between the gate electrode and the source electrode that occurs when current flowing through filter reactors 2, 3 is commutated, to thereby reduce the probability itself of occurrence of arm short circuit.

Next, a description is given of causes for occurrence of oscillation of the drain-source voltage of the semiconductor switching device in the event of arm short circuit.

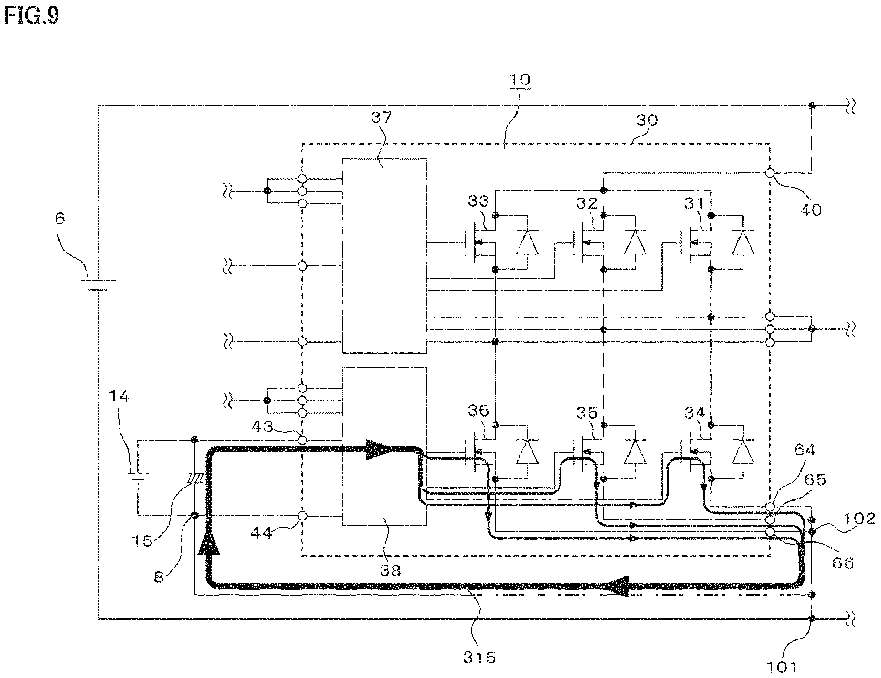

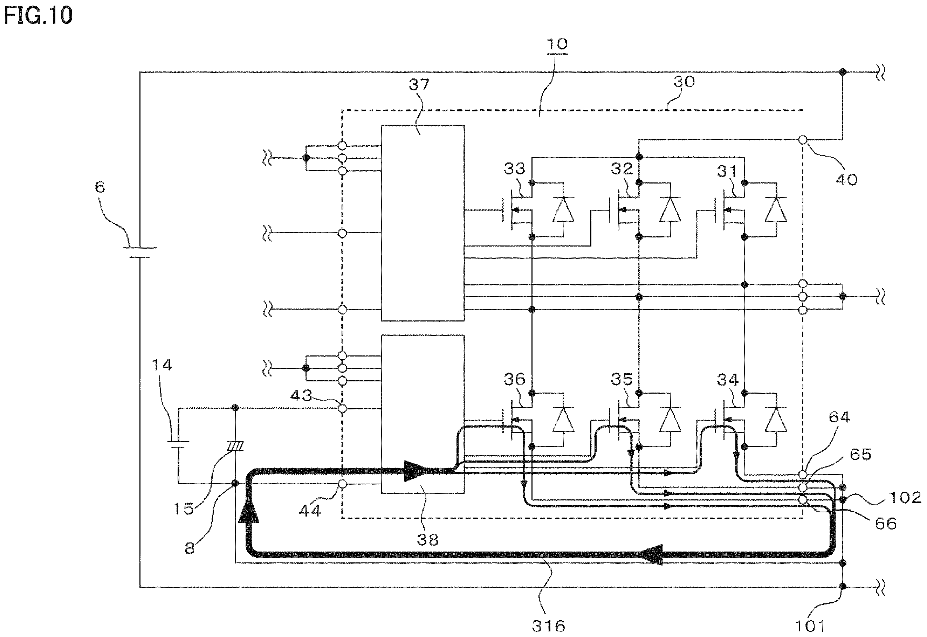

Fig. 9 is a diagram showing a behavior of resonant current flowing through the drive circuit in the event of arm short circuit in the power converter of the comparative example. Fig. 10 is a diagram showing a behavior of another resonant current flowing through the drive circuit in the event of arm short circuit in the power converter of the comparative example. Figs. 9 and 10 are each a partial circuit diagram showing a part of the power converter equipped with no impedance element between reference potential connection point 8 and negative electrode connection point 102.

A path 315 in Fig. 9 is a path of resonant current flowing through the drive circuit in the event of arm short circuit, and a path 316 in Fig. 10 is a path of resonant current flowing through the drive circuit in the event of arm short circuit. Path 315 in Fig. 9 and path 316 in Fig. 10 are each shown as a closed circuit having arrows in a single direction. The resonant current flowing through the drive circuit in the event of arm short circuit, however, flows not only in the direction indicated by the arrows of path 315 and path 316 but also in the opposite direction to the direction indicated by the arrows of path 315 and path 316.

A description is given for example of a case where while lower arm semiconductor switching devices are ON, upper arm semiconductor switching devices are turned on to cause arm short circuit. In this case, in a state before occurrence of the arm short circuit, the lower arm semiconductor switching devices are in the ON state and the upper arm semiconductor switching devices are in the OFF state. Therefore, the voltage of DC power supply 6 connected in parallel to the arm circuit is applied between the drain electrode and the source electrode of the upper arm semiconductor switching devices that are all in the OFF state.

When the upper arm semiconductor switching devices are turned on due to an influence of noise or the like to cause arm short circuit, the upper arm semiconductor switching devices and the lower arm semiconductor switching devices divide the voltage of DC power supply 6 at a division ratio determined by the self impedance of each semiconductor switching device. Therefore, the voltage at the midpoint of the arm circuit that is a connection point of the upper arm semiconductor switching devices and the lower arm semiconductor switching devices is changed sharply, resulting in a sharp increase of dV/dt representing a rate of change in drain-source voltage the lower arm semiconductor switching device over time. This large dV/dt causes current to flow in the direction from the drain electrode to the gate electrode for charging a parasitic capacitance between the gate electrode and the drain electrode of the lower arm semiconductor switching device. This current results in resonant current flowing through path 315 shown in Fig. 9 and path 316 shown in Fig. 10. This resonant current is more conspicuous when the ratio of the resonance frequency of the resonant current occupying the frequency component of dV/dt generated due to arm short circuit is high.

The resonant current flowing in path 315 in Fig. 9 and the resonant circuit flowing in path 316 in Fig. 10 are each current flowing in the direction indicated by the arrows shown on path 315 and path 316 and in the opposite direction to the arrows indicated by path 315 and path 316 as mentioned above. In other words, the resonant current flowing through path 315 and path 316 is resonant current flowing through a series resonant circuit constituted of the parasitic capacitor between the gate electrode and the source electrode of lower arm semiconductor switching devices and the inductance of paths 315 and 316.

More specifically, as indicated by path 315 in Fig. 9, this resonant current flows in the path through the positive terminal of smoothing capacitor 15 serving as a drive power supply, positive drive power supply terminal 43, and lower arm drive circuit 38, branches off to respective gate electrodes of lower arm semiconductor switching devices 34, 35, 36 to flow through each source electrode to meet negative electrode connection point 102 which is a connection point of low-voltage input terminals 64, 65, 66, and then flows through the line between negative electrode connection point 102 and reference potential connection point 8, and back to the negative electrode of smoothing capacitor 15, and in a path in the opposite direction to the above-described one.

More specifically, this resonant current flows, as indicated by path 316 in Fig. 10, through reference potential connection point 8, negative drive power supply terminal 44, and lower arm drive circuit 38 that are connected to the negative terminal of smoothing capacitor 15 serving as a drive power supply, then branches off to respective gate electrodes of lower arm semiconductor switching devices 34, 35, 36 to flow through respective source electrodes to meet at negative electrode connection point 102 which is a connection point between low-voltage input terminals 64, 65, 66, and then flows through a line between negative electrode connection point 102 and reference potential connection point 8, and back to reference potential connection point 8, and also flows in the path in the opposite direction to the above-described direction.

Therefore, in the case where three semiconductor switching devices 34, 35, 36 are connected in parallel as shown in Figs. 9 and 10, the parasitic capacitance between the gate electrodes and the source electrodes of the lower arm semiconductor switching devices is a synthetic capacitance of respective parasitic capacitances between the gate electrodes and the source electrodes of semiconductor switching devices 34, 35, 36. The inductance of path 315 and path 316 is mainly an inductance of a wire between reference potential connection point 8 and negative electrode connection point 102 which is a connection point of low-voltage input terminals 64, 65, 66 of power module 10.

According to the present invention, an impedance element having an inductance increasing the inductance of path 315 or path 316 is disposed in path 315 shown in Fig. 9 or path 316 shown in Fig. 10 to thereby suppress oscillation of the drain-source voltage of the semiconductor switching device that is generated when arm short circuit occurs. The impedance elements may be disposed respectively between negative electrode connection point 102 and reference potential connection point 8 and between negative electrode connection point 103 and reference potential connection point 9 shown in Fig. 4. Alternatively, the impedance element may be disposed between respective positive terminals of smoothing capacitors 15 and 25 and positive drive power supply terminal 43, between lower arm drive circuit 38 and respective gate electrodes of semiconductor switching devices 34, 35, 36, between low-voltage input terminals 64, 65, 66 and negative electrode connection points 102 and 103, or between reference potential connection points 8 and 9 and negative drive power supply terminal 44. In this case as well, the effect of suppressing oscillation of the drain-source voltage of the semiconductor switching device occurring in the event of arm short circuit is obtained.

Because the reference potential of controller 7 and reference potential connection points 8 and 9 are connected to the same potential, the reference potential of control signal input terminals 54, 55, 56 of the lower arm is identical to the reference potential of controller 7. When impedance elements are disposed between reference potential connection points 8 and 9 and negative drive power supply terminal 44, the reference potential of controller 7 is not identical to the reference potential of lower arm drive circuit 38. Therefore, even when the voltage value of a control signal that is output from controller 7 is constant, the voltage value of the control signal may vary relative to the reference potential of lower arm drive circuit 38, which may make the operation of lower arm drive circuit 38 unstable. It is therefore more preferable to dispose the impedance element at a location other than the locations between reference potential connection points 8 and 9 and negative drive power supply terminal 44.

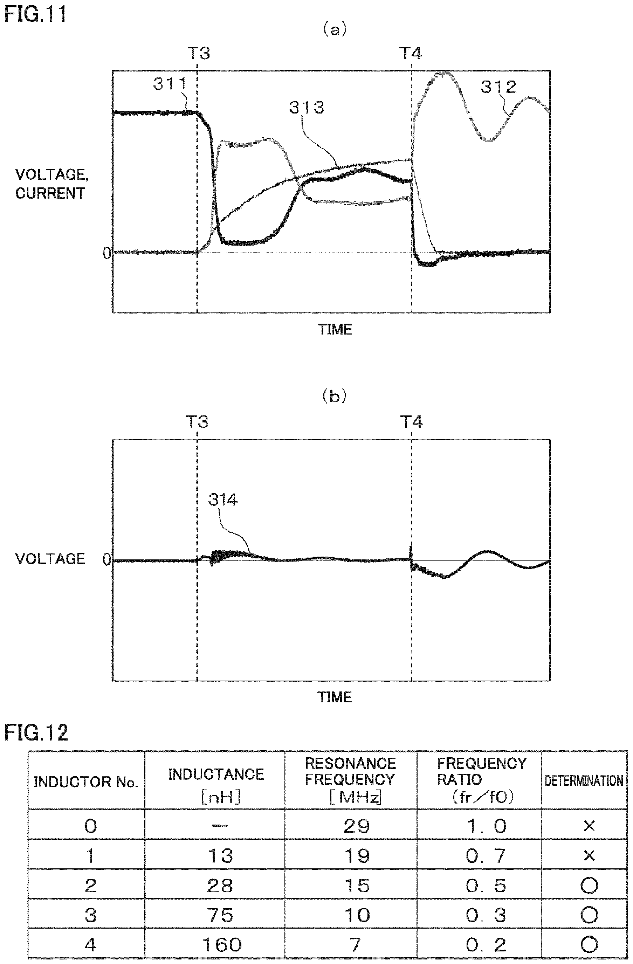

Fig. 11 shows respective waveforms of drain-source voltages of upper and lower arms, arm short circuit current, and a source voltage in the event of arm short circuit in the power converter in Embodiment 1 of the present invention. Power converter 100 in which the waveforms in Fig. 11 are generated is a power converter having the configuration shown in Fig. 4, and differs from the power converter in which the waveforms in Fig. 8 are generated in that the former power converter includes impedance element 11 between negative electrode connection point 102 and reference potential connection point 8 and impedance element 21 between negative electrode connection point 103 and reference potential connection point 9. As each of impedance elements 11 and 21, a ferrite bead inductor which was a surface-mounted inductor having an inductance of 28 nH was used. This inductor had a DC resistance of 10 mΩ and an impedance of 5 Ω at 30 MHz.

The horizontal axis of Fig. 11 (a) represents time, and the vertical axis thereof represents the magnitude of a drain-source voltage 311 of the upper arm and the magnitude of a drain-source voltage 312 of the lower arm, and the magnitude of arm short circuit current 313 flowing through the upper and lower arms that are short-circuited. The drain-source voltage of the upper arm is a measured voltage between high-voltage input terminal 40 of power module 10 of the U phase arm circuit and output terminals 61, 62, 63 thereof that are short-circuited. The drain-source voltage of the lower arm is a measured voltage between negative electrode connection point 102 and output terminals 61, 62, 63 that are short-circuited of power module 10 of the U phase arm circuit. The horizontal axis of Fig. 11 (b) represents time, and the vertical axis thereof represents a source voltage 314 that is a voltage at negative electrode connection point 102 with respect to reference potential connection point 8.

As shown in Fig. 11 (a), in the period from time T3 to time T4, arm short circuit current flows 313, from which occurrence of arm short circuit can be confirmed. Power converter 100 of the present invention differs from the case shown in Fig. 8 in that drain-source voltage 311 of the upper arm and drain-source voltage 312 of the lower arm shown in Fig. 11 (a) have almost no oscillation. As shown in Fig. 11 (b), source voltage 314 with respect to reference potential connection point 8 also has almost no oscillation. In other words, in power converter 100 of the present invention, impedance element 11 is disposed between negative electrode connection point 102 and reference potential connection point 8 and impedance element 21 is disposed between negative electrode connection point 103 and reference potential connection point 9, and therefore, oscillation of the drain-source voltage of the semiconductor switching device that is generated in the event of arm short circuit can be suppressed. Likewise, the impedance element may also be disposed in path 315 shown in Fig. 9 or path 316 shown in Fig. 10 to suppress oscillation of the drain-source voltage of the semiconductor switching device that is generated in the event of arm short circuit.

Regarding power converter 100 in which the waveforms in Fig. 11 are generated, the protective function of power converter 100 worked properly. After the waveforms in Fig. 11 were measured, all the semiconductor switching devices were turned off and power converter 100 was properly stopped from operating.

Next, a description is given of the results of examination of the inductance values of impedance elements 11 and 21 from which the effects of the present invention are derived, in power converter 100 shown in Fig. 4.

Fig. 12 is a diagram showing the inductance values of impedance elements in the power converter and the results of determination of effects in Embodiment 1 of the present invention. While the following description relates to the U phase, the description of the U phase is applied as well to the W phase. In Fig. 12, "INDUCTOR No." is ID number of an inductor used for impedance element 11 of power converter 100 shown in Fig. 4. INDUCTOR No. 0 means that no impedance element 11 is disposed and the wiring pattern on which impedance element 11 is disposed is short-circuited with a shortest distance, using a conductor having a cross-sectional area larger than the cross-sectional area of the wiring pattern. Under "INDUCTANCE [nH]" the inductance of the inductor represented by INDUCTOR No. is shown.

"RESONANCE FREQUENCY [MHz]" is a resonance frequency of a series resonant circuit made up of the inductance of a closed circuit through which drive current flows for turning on semiconductor switching devices 34, 35, 36, and the synthetic capacitance of parasitic capacitances between the gate electrodes and the source electrodes of semiconductor switching devices 34, 35, 36. The parasitic capacitance between the gate electrode and the source electrode of each of semiconductor switching devices 34, 35, 36 was 1 nF, and therefore, the synthetic capacitance of the three semiconductor switching devices connected in parallel was 3 nF. In the case of INDUCTOR No. 0 where the connecting part of impedance element 11 is short circuited with a shortest distance, the inductance of the closed circuit through which drive current flows for turning on the semiconductor switching devices was 10 nH. Accordingly, the inductance of the closed circuit through which drive current flows for turning on the semiconductor switching devices in the case of INDUCTOR Nos. 1 to 4 has a magnitude determined by adding 10 nH to the inductance of INDUCTOR Nos. 1 to 4 shown in Fig. 12.

"FREQUENCY RATIO (fr/f0)" is a ratio of resonance frequency fr to resonance frequency f0, where resonance frequency fr is determined by the inductance of the closed circuit through which drive current flows for turning on the semiconductor switching devices and which includes the impedance element, and the parasitic capacitance between the gate electrode and the source electrode of the semiconductor switching device in the case of INDUCTOR Nos. 1 to 4, and resonance frequency f0 is determined by the inductance of a closed circuit through which drive current flows for turning on semiconductor switching devices and which includes no impedance element, and the parasitic capacitance between the gate electrode and the source electrode of the semiconductor switching device in the case of INDUCTOR No. 0. As to INDUCTOR No. 0, the closed circuit includes no impedance element and therefore, the resonance frequency in the state where no impedance element is included, i.e., the state where a wiring pattern on which impedance element 11 is disposed is short-circuited with a shortest distance, using a conductor having a cross-sectional area larger than the cross-sectional area of the wiring pattern. Therefore, in the case of INDUCTOR No. 0, both fr and f0 are 29 MHz and accordingly the frequency ratio is 1.0.

"DETERMINATION" is the result of determination as to whether the protective function works properly when arm short circuit occurs in power converter 100 to properly stop power converter 100 from operating. The result of determination is "O" when power converter 100 is properly stopped from operating, and the result of determination is "X" when the protective function does not properly work and power converter 100 is not stopped from operating.

As shown in Fig. 12, in the case of INDUCTOR Nos. 2 to 4, the protective function properly worked to properly stop power converter 100 from operating in the event of occurrence of arm short circuit, when the voltage value of DC power supply 6 was the lower limit or the upper limit of the rated voltage. The result of determination is therefore "O". In contrast, in the case of INDUCTOR No. 1, the protective function worked property when the voltage value of DC power supply 6 was the lower limit of the rated voltage, however, when the voltage value of DC power supply 6 was the upper limit of the rated voltage, the protective function did not work properly and power converter 100 was not stopped from operating. The result of determination is therefore "X". In the case of INDUCTOR No. 0 where no impedance element is included, the protective function did not work properly and power converter 100 was not stopped from operating, regardless of whether the voltage value of DC power supply 6 is the lower limit or the upper limit. In the case of INDUCTOR No. 0, therefore, the result of determination is also "X".

As seen from Fig. 12, the result of determination is "O" when the inductance of the inductor which is impedance element 11 is 28 nH or more. For INDUCTOR No. 2, the frequency ratio is 0.5. For INDUCTOR No. 3, the frequency ratio is 0.3. For INDUCTOR No. 4, the frequency ratio is 0.2. In other words, the inductance of impedance element 11 may be set so that resonance frequency fr of the closed circuit through which drive current flows to turn on the lower arm semiconductor switching devices and in which impedance element 11 is included as shown in Fig. 4 is 1/2 or less of resonance frequency f0 of a closed circuit through which drive current flows to turn on the lower arm semiconductor switching devices and in which the opposite ends of impedance element 11 are short circuited. In this way, oscillation of the drain-source voltage of the semiconductor switching device in the event of occurrence of arm short circuit is suppressed, and the protective function works properly and thus power converter 100 can be properly stopped from operating.

The inductance of the closed circuit through which drive current flows for turning on the lower arm semiconductor switching devices and in which no impedance element 11 is included may be measured by causing impedance element 11 to be short-circuited with a shortest distance, using a conductor having a cross-sectional area larger than the cross-sectional area of the wiring pattern as described above, by means of an impedance analyzer or the like. For example, the inductance may be calculated from the frequency of oscillation of the drain-source voltage in the event of arm short circuit shown in Fig. 8. As described above, the frequency of oscillation of the drain-source voltage in Fig. 8 is the resonance frequency of a resonant circuit made up of the parasitic capacitance between the gate electrode and the source electrode of the lower arm semiconductor switching devices and the inductance of the closed circuit through which drive current flows. Therefore, the parasitic capacitance between the gate electrode and the source electrode of the lower arm semiconductor switching device can be measured by means of an impedance analyzer or the like to easily calculate the inductance of the closed circuit through which drive current flows.

As seen from the above, according to Embodiment 1 of the present invention, the closed circuit through which drive current flows for turning on the lower arm semiconductor switching devices is equipped with the impedance element having the inductance increasing the inductance of this closed circuit. Oscillation of the drain-source voltage of the semiconductor switching device in the event of arm short circuit can therefore be suppressed. Accordingly, when arm short circuit occurs, the protective function of the power converter can work properly to properly stop the power converter from operating.

Moreover, in the closed circuit through which drive current flows for turning on the lower arm semiconductor switching devices, the impedance element having the inductance increasing the inductance of this closed circuit is disposed. Therefore, a voltage increase between the gate electrode and the source electrode of the semiconductor switching device in the event of current commutation can be suppressed, and the probability of occurrence of arm short circuit can be reduced.

Further, the inductance of the impedance element disposed in the closed circuit through which drive current flows for turning on the lower arm semiconductor switching devices is set so that a resonance frequency of the closed circuit equipped with the impedance element is 1/2 or less of a resonance frequency of a closed circuit in which the opposite ends of the impedance element are short-circuited. Therefore, oscillation of the drain-source voltage of the semiconductor switching device in the event of occurrence of arm short circuit can be suppressed more reliably. Accordingly, when arm short circuit occurs, the protective function of the power converter can be worked more reliably to properly stop the operation of the power converter.

Moreover, each of the upper arm and the lower arm of the arm circuit is constituted of a plurality of semiconductor switching devices connected in parallel, and these semiconductor switching devices are driven in parallel. Main circuit current of the power converter can therefore be increased. Further, there is provided the negative electrode connection point at which respective negative electrodes of all of a plurality of semiconductor switching devices constituting the lower arm are connected together, and the impedance element is disposed between the negative electrode connection point and the reference potential connection point. Difference in current flowing through a plurality of semiconductor switching devices can thus be reduced.

Further, the semiconductor switching devices are arranged inside a single power module, while the impedance element is arranged outside the power module. Even when the wiring pattern of the power converter is changed and the inductance of the closed circuit through which drive current flows, the impedance element can be replaced freely to make adjustments.

### Second Embodiment

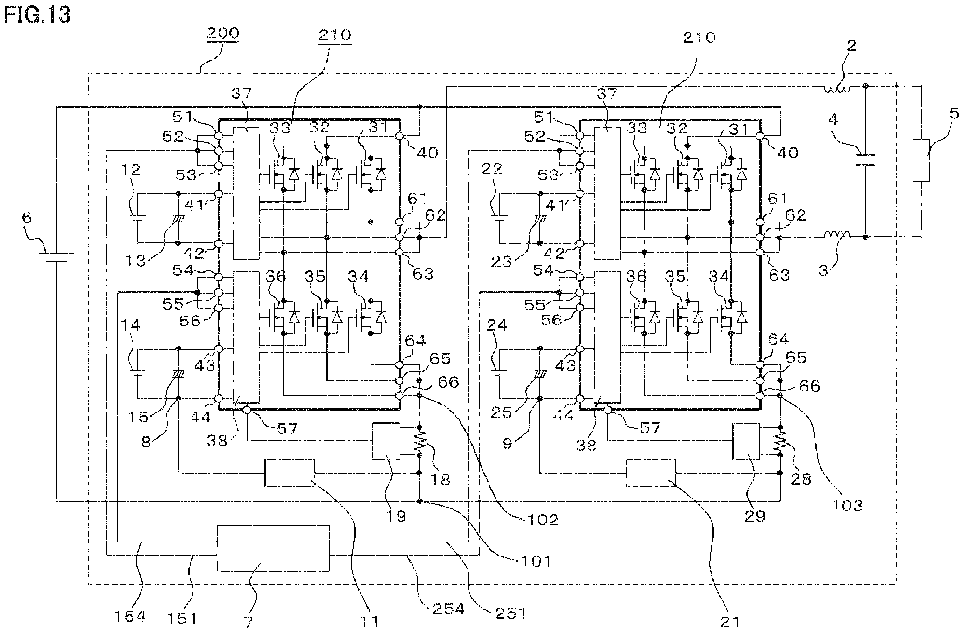

Fig. 13 is a circuit diagram showing a configuration of a power converter in Embodiment 2 of the present invention. In Fig. 13, any component denoted by the same reference as Fig. 4 has the same or corresponding configuration, and the description thereof is not repeated. Power converter 200 shown in Fig. 13 differs from power converter 100 shown in Fig. 4 in Embodiment 1 of the present invention in that the former includes a current detector for detecting the magnitude of current flowing through a semiconductor switching device, and the power module has a protective function of stopping switching of semiconductor switching devices when the current detector detects arm short circuit current.

As shown in Fig. 13, power converter 200 includes a U phase arm circuit and a W phase arm circuit each formed of a power module 210. Power module 210 has a similar configuration to power module 10 described above in connection with Embodiment 1. Power module 210, however, differs from power module 10 in that the former includes a current detection input terminal 57 connected to lower arm drive circuit 38 and has a protective function of stopping switching of each semiconductor switching device by outputting a drive voltage for turning off the semiconductor switching device based on the magnitude of a voltage that is input to current detection input terminal 57.

Low-voltage input terminals 64, 65, 66 of U phase power module 210 are connected to a negative electrode connection point 102, and a shunt resistor 18 serving as a current detector is connected between negative electrode connection point 102 and a negative terminal connection point 101 connected to the negative terminal of DC power supply 6. Shunt resistor 18 is a resistor having an electrical resistance on the order of a few mΩ. The voltage generated across shunt resistor 18 is amplified by an amplifier 19 to be input to current detection input terminal 57 of power module 210. Between reference potential connection point 8 and a connection point of shunt resistor 18 and negative terminal connection point 101, an impedance element 11 is disposed. As described above in connection with Embodiment 1, impedance element 11 is disposed in a closed circuit through which drive current flows for turning on lower arm semiconductor switching devices, and has an inductance increasing the inductance of this closed circuit.

Likewise, low-voltage input terminals 64, 65, 66 of W phase power module 210 are connected to a negative electrode connection point 103. A shunt resistor 28 serving as a current detector is connected between negative electrode connection point 103 and negative terminal connection point 101 connected to the negative terminal of DC power supply 6. The voltage generated across shunt resistor 28 is amplified by an amplifier 29 to be input to a current detection input terminal 57 of W phase power module 210. Between reference potential connection point 9 and a connection point of shunt resistor 28 and negative terminal connection point 101, an impedance element 21 similar to impedance element 11 is disposed.

A lower arm drive circuit 38 of power module 210 controls a drive voltage applied to respective gate electrodes of lower arm semiconductor switching devices 34, 35, 36, depending on a voltage value that is input to current detection input terminal 57. When the voltage value input to current detection input terminal 57 is a predetermined threshold or less, lower arm drive circuit 38 outputs a drive voltage for controlling ON and OFF of lower arm semiconductor switching devices 34, 35, 36, based on a control signal input to control signal input terminals 54, 55, 56. In contrast, when the voltage value input to current detection input terminal 57 is larger than the predetermined threshold, lower arm drive circuit 38 outputs a drive voltage for turning off lower arm semiconductor switching devices 34, 35, 36, i.e., a voltage around 0 V, regardless of the control signal input to control signal input terminals 54, 55, 56, to stop switching of lower arm semiconductor switching devices 34, 35, 36.

In Fig. 13, one end of impedance element 11 is connected between shunt resistor 18 and negative terminal connection point 101. Alternatively, it may be connected between negative electrode connection point 102 and shunt resistor 18. In Fig. 13, one end of impedance element 21 is connected between shunt resistor 28 and negative terminal connection point 101, it may be connected between negative electrode connection point 103 and shunt resistor 28. In other words, while Fig. 13 shows shunt resistors serving as current detectors disposed on a common wire through which both main circuit current and drive circuit current flow, the shunt resistor serving as a current detector may be disposed on the main circuit line.

Fig. 13 shows shunt resistors used as current detectors. The current detector having another configuration such as current transformer may be used. Regardless of the configuration of the current detector, amplifiers 19 and 29 each output a voltage depending on the magnitude of current flowing through the current detector, to current detection input terminal 57 of power module 210.

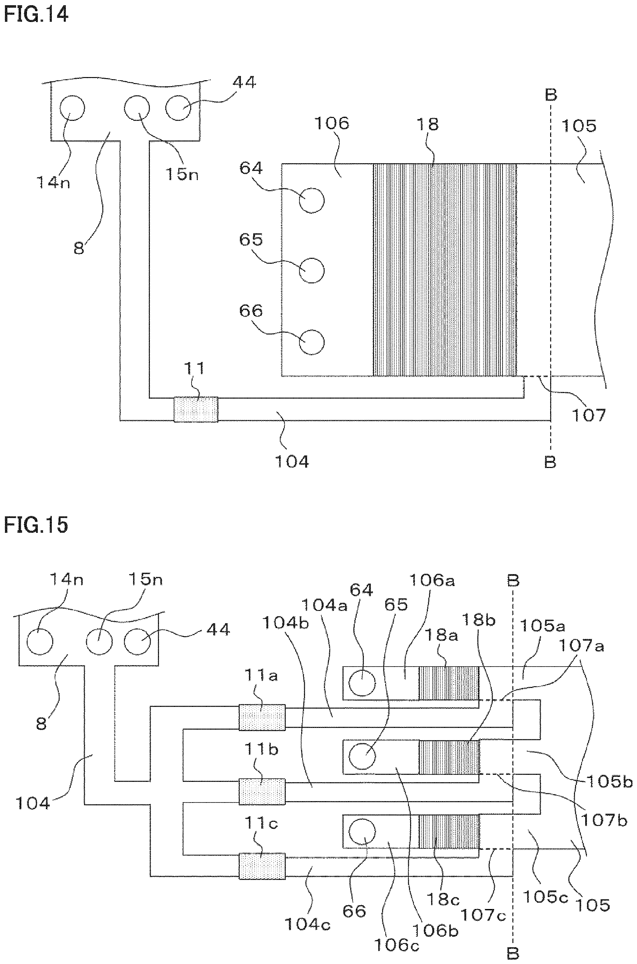

Fig. 14 is a partial pattern diagram showing a part of a wiring pattern of the power converter in Embodiment 2 of the present invention. Fig. 15 is also a partial pattern diagram showing a part of another wiring pattern of the power converter in Embodiment 2 of the present invention. The wiring patterns in Figs. 14 and 15 each show the wiring pattern between low-voltage input terminals 64, 65, 66 and negative drive power supply terminal 44 and their periphery of power module 210 in power converter 200 shown in Fig. 13.

In Fig. 14, broken line B-B is a boundary between a common line and a main circuit line. The left side of broken line B-B is common line 106, and the right side of broken line B-B is main circuit line 105, as seen on the drawing. Broken line 107 is a boundary between the common line and a drive circuit line. The upper side of broken line 107 is common line 106, and the lower side of broken line 107 is drive circuit line 104, as seen on the drawing. Low-voltage input terminals 64, 65, 66 of power module 210 are connected, by soldering or the like, to a negative electrode connection point formed of a planer pattern, and one end of shunt resistor 18 is connected to common line 106 on which the negative electrode connection point is disposed. To the other end of shunt resistor 18, main circuit line 105 in which main circuit current flows and drive circuit line 104 in which drive current flows are connected.

Drive circuit line 104 is connected to reference potential connection point 8 formed of a planar pattern, and impedance element 11 is disposed in drive circuit line 104. To reference potential connection point 8, a negative terminal 15n of smoothing capacitor 15 serving as a drive power supply is connected by soldering or the like, and negative drive power supply terminal 44 of power module 210 is connected in the vicinity of negative terminal 15n by soldering or the like. To reference potential connection point 8, a negative terminal 14n of control power supply 14 is connected by soldering or the like.

As shown in Fig. 14, low-voltage input terminals 64, 65, 66 of power module 210 in which three lower arm semiconductor switching devices 34, 35, 36 are connected in parallel and driven in parallel are connected to the planar negative electrode connection point, and common shunt resistor 18 is disposed. Therefore, the impedance of the wire and/or shunt resistor 18 connected to the semiconductor switching devices can be made common to the semiconductor switching devices. In this way, difference among the semiconductor switching devices in terms of current flowing through each semiconductor switching device can be reduced, and the upper limit of the main circuit current in the whole arm circuit in which the semiconductor switching devices are driven in parallel can be increased.

In Fig. 15, broken line B-B is a boundary between a common line and a main circuit line. The left side of broken line B-B is the common line and the right side thereof is the main circuit line, as seen on the drawing. Broken line 107a, broken line 107b, and broken line 107c are each a boundary between the common line and a drive circuit line. The upper side of each of broken line 107a, broken line 107b, and broken line 107c is the common line and the lower side thereof is the drive circuit line, as seen on the drawing. The wiring pattern shown in Fig. 15 connects low-voltage input terminals 64, 65, 66 of power module 210 to separate common lines 106a, 106b, 106c, respectively by soldering or the like, and common lines 106a, 106b, 106c are equipped with shunt resistors 18a, 18b, 18c, respectively. To shunt resistor 18a, main circuit line 105a and drive circuit line 104a are connected. To shunt resistor 18b, main circuit line 105b and drive circuit line 104b are connected. To shunt resistor 18c, main circuit line 105c and drive circuit line 104c are connected. Main circuit lines 105a, 105b, 105c are connected to one main circuit line 105.

Drive circuit lines 104a, 104b, 104c are equipped with impedance elements 11a, 11b, 11c, respectively. Drive circuit lines 104a, 104b, 104c are connected to one drive circuit line 104 and connected to reference potential connection point 8 formed by a planar pattern. To reference potential connection point 8, a negative terminal 15n of smoothing capacitor 15 serving as a drive power supply, as well as negative drive power supply terminal 44 of power module 210 and negative terminal 14n of control power supply 14 are connected by soldering or the like.

As shown in Fig. 15, low-voltage input terminals 64, 65, 66 to which respective source electrodes of three lower arm semiconductor switching devices 34, 35, 36 are connected are connected to separate common lines 106a, 106b, 106c, respectively, and they are equipped with shunt resistors 18a, 18b, 18c, respectively. Thus, current flowing through the semiconductor switching devices can be detected individually. In the case where three lower arm semiconductor switching devices 34, 35, 36 are driven in parallel and the wiring pattern as shown in Fig. 15 is used, there arises difference among the semiconductor switching devices in terms of impedance of the line connected to each semiconductor switching device, resulting in difference among the semiconductor switching devices in terms of current flowing through each semiconductor switching device. The upper limit of the main circuit current in the whole arm circuit may become lower than that in the case of the wiring pattern shown in Fig. 14.

In view of the above, while the wiring pattern of power converter 200 in Embodiment 2 of the present invention may be configured as shown in Fig. 15, the wiring pattern is more preferably configured as shown in Fig. 14.

Next, operation of power converter 200 is described.

While the following description relates to the U phase, the description of the U phase is applied as well to the W phase. When arm short circuit occurs in the U phase arm circuit of power converter 200 shown in Fig. 13, arm short circuit current flows through shunt resistor 18, and a voltage proportional to the magnitude of the arm short circuit current is generated across shunt resistor 18. Amplifier 19 amplifies the voltage across shunt resistor 18 and outputs the amplified voltage to current detection input terminal 57 of power module 210.

The arm short circuit current is larger than main circuit current in normal operation. Therefore, when the arm short circuit current flows through shunt resistor 18, a voltage larger than a threshold voltage is input to current detection input terminal 57. When a voltage larger than the threshold voltage is input to current detection input terminal 57, lower arm drive circuit 38 outputs, to the gate electrode of each semiconductor switching device, a drive voltage that causes semiconductor switching devices 34, 35, 36 to be turned off. As a result, lower arm semiconductor switching devices 34, 35, 36 are turned off and recovery from the arm short circuit is accomplished.

Power module 210 may output the drive voltage that causes the semiconductor switching devices to be turned off, not only from lower arm drive circuit 38 but also from upper arm drive circuit 37, based on the voltage value that is input to current detection input terminal 57.

In the case where power module 210 thus includes current detection input terminal 57 and has a protective function of turning off the semiconductor switching devices based on a voltage value that is input to current detection input terminal 57, malfunction due to noise can be reduced and protection can be given more reliably. However, as described above in connection with Embodiment 1, if oscillation of the drain-source voltage of the semiconductor switching device is generated in the event of arm short circuit, the oscillation of the drain-source voltage causes noise and accordingly the protective function of power module may not work properly. In particular, because a voltage generated depending on the magnitude of current flowing through a current detector such as shunt resistor is small, it is likely to be affected by noise.

As shown in Fig. 13, power converter 200 in Embodiment 2 of the present invention includes impedance element 11 and impedance element 21 that are each arranged between the line connected to the source electrodes of the semiconductor switching devices and reference potential connection point 8/9, and therefore, oscillation of the drain-source voltage of the semiconductor switching device in the event of arm short circuit can be suppressed as described above in connection with Embodiment 1. As a result, noise generated due to oscillation of the drain-source voltage of the semiconductor switching devices is suppressed, and the protective function of power module 210 is prevented from not operating properly. Thus, in the event of arm short circuit, the operation of power converter 200 can be stopped properly.

Moreover, as described above in connection with Embodiment 1, impedance elements 11 and 21 can be disposed to reduce an increase of the voltage between the gate electrode and the source electrode when current is commutated. Accordingly, the probability of occurrence of arm short circuit itself can be reduced.

As seen from the above, according to Embodiment 2 of the present invention, a closed circuit through which drive current flows for turning on lower arm semiconductor switching devices has an impedance element disposed in the closed circuit, and the impedance element has an inductance increasing the inductance of the closed circuit. A current detector is disposed between the negative electrodes of the lower arm semiconductor switching devices and negative terminal connection point 101 connected to the negative terminal of DC power supply 6. Based on the result of detection by the current detector, the drive voltage of the semiconductor switching device is controlled. Accordingly, oscillation of the drain-source voltage of the semiconductor switching device in the event of arm short circuit can be suppressed and thereby noise can be suppressed. In response to detection of the arm short circuit by the current detector, the protective function can work properly to properly stop operation of the power converter.

While the description of Embodiments 1 and 2 relates to the power converter that is a DC/AC inverter constituted of a full bridge circuit including two arm circuit sets each including both upper arm semiconductor switching devices and lower arm semiconductor switching devices, the power converter may be a DC/AC inverter constituted of a half bridge circuit including one arm circuit set. The power converter may also be a three-phase inverter equipped with three arm circuit sets to output three-phase AC voltage. The power converter may be a DC/DC converter such as step-up converter or step-down converter for synchronous rectification by means of an arm circuit. The power converter may also be a DC/DC converter in which only the lower arm includes semiconductor switching devices and the upper arm is made up of diodes.

### REFERENCE SIGNS LIST

1, 100, 200 power converter; 8, 9 reference potential connection point; 10, 210 power module; 11, 21 impedance element; 14, 24 control power supply; 15, 25 smoothing capacitor; 31, 32, 33, 131, 231 semiconductor switching device; 34, 35, 36, 134, 234 semiconductor switching device; 38, 138, 238 lower arm drive circuit; 43 positive drive power supply terminal; 44 negative drive power supply terminal; 101 negative terminal connection point; 102, 103 negative electrode connection point; 104, 104a, 104b, 104c drive circuit line; 105, 105a, 105b, 105c main circuit line; 106, 106a, 106b, 106c common line

## Claims

1. A power converter comprising:
a first semiconductor switching device (134, 34, 35, 36) having a positive electrode, a negative electrode, and a control electrode to which a drive voltage with respect to the negative electrode as a reference is applied;
a drive power supply (15) having a positive terminal and a negative terminal and configured to supply, to the control electrode, drive current to turn on the first semiconductor switching device;
a drive circuit (138, 38) connected to the positive terminal of the drive power supply, the negative terminal of the drive power supply, the negative electrode of the first semiconductor switching device, and the control electrode of the first semiconductor switching device, and configured to output the drive voltage to the control electrode of the first semiconductor switching device; and
an impedance element (11, 21) disposed in a closed circuit through which the drive current flows and causing an inductance of the closed circuit to increase, the closed circuit including the positive terminal of the drive power supply, the control electrode of the first semiconductor switching device, the negative electrode of the first semiconductor switching device, and the negative terminal of the drive power supply,
**characterised in that**
the impedance element (11,21) is adapted to change a resonance frequency of a resonance circuit toward a low frequency side, the resonance circuit including the inductance of the closed circuit and a parasitic capacitance between the control electrode and the negative electrode of the first semiconductor switching device,
wherein the impedance element (11,21) has a characteristic that a resistance component increases with increase of a frequency.

2. The power converter according to claim 1, wherein
the drive circuit (38, 138) is connected to a reference potential connection point (8) to which the negative terminal of the drive power supply and the negative electrode of the first semiconductor switching device are connected, and
the impedance element (11, 21) is disposed between the negative electrode of the first semiconductor switching device (134, 34, 35, 36) and the reference potential connection point.

3. The power converter according to claim 2, comprising:
a negative terminal connection point (102) connected to a negative terminal of a DC power supply (6) configured to supply main circuit current;
a common line (106) connected to the negative electrode of the first semiconductor switching device (34, 35, 36), the main circuit current and the drive current flowing through the common line;
a main circuit line (105) connecting the common line to the negative terminal connection point, the main circuit current flowing through the main circuit line; and
a drive circuit line (104) connecting the common line to the reference potential connection point (8), the drive current flowing through the drive circuit line, wherein
the impedance element (11) is disposed in the drive circuit line.

4. The power converter according to any one of claims 1 to 3, wherein
the drive circuit (38) has a gate resistor (84, 85, 86) connected to the control electrode of the first semiconductor switching device (34, 35, 36), and
the impedance element (11) is provided separately from the gate resistor.

5. The power converter according to any one of claims 1 to 4, wherein the first semiconductor switching device is constituted of a plurality of first semiconductor switching devices (34, 35, 36) connected in parallel to each other, each of the plurality of first semiconductor switching devices having the positive electrode, the negative electrode, and the control electrode.

6. The power converter according to claim 5, wherein the plurality of first semiconductor switching devices (34, 35, 36) have a period during which all the plurality of first semiconductor switching devices are ON.

7. The power converter according to claim 5 or 6, comprising a negative electrode connection point (102) to which all the negative electrodes of the plurality of first semiconductor switching devices (34, 35, 36) are connected, wherein
the impedance element (11) is connected between the negative electrode connection point and the reference potential connection point (8).

8. The power converter according to any one of claims 1 to 7, further comprising a second semiconductor switching device (131, 31, 32, 33) connected in series to the positive electrode of the first semiconductor switching device (134, 34, 35, 36).

9. The power converter according to claim 8, wherein the second semiconductor switching device is constituted of a plurality of the second semiconductor switching devices (31, 32, 33) connected in parallel to each other.

10. The power converter according to any one of claims 1 to 9, comprising a current detector (18, 28) connected to the negative electrode of the first semiconductor switching device (134, 34, 35, 36), wherein
the drive circuit (138, 38) controls output of the drive voltage based on a result of detection by the current detector.

11. The power converter according to any one of claims 1 to 10, wherein
the first semiconductor switching device (31, 32, 33, 34) is disposed within one power module (10), and
the impedance element (11, 21) is disposed outside the power module.

12. The power converter according to any one of claims 1 to 11, wherein
the impedance element (11, 21) has an inductance that is set so that the resonance frequency is 1/2 or less of a resonance frequency determined by the parasitic capacitance and an inductance of the closed circuit without the impedance element.

13. The power converter according to any one of claims 1 to 12, wherein the impedance element (11,21) is an inductor having a core.

14. The power converter according to any one of claims 1 to 13, wherein the first semiconductor switching device (134, 34, 35, 36) is a MOSFET formed from a silicon carbide semiconductor material.

## Patentansprüche

1. Leistungswandler, der Folgendes umfasst:
eine erste Halbleiterschaltvorrichtung (134, 34, 35, 36), die eine positive Elektrode, eine negative Elektrode und eine Steuerelektrode aufweist, an die eine Ansteuerspannung in Bezug auf die negative Elektrode als Referenz angelegt wird;
eine Ansteuerleistungsversorgung (15), die einen positiven Anschluss und einen negativen Anschluss aufweist und ausgelegt ist, um die Steuerelektrode mit Ansteuerstrom zu versorgen, um die erste Halbleiterschaltvorrichtung einzuschalten;
eine Ansteuerschaltung (138, 38), die mit dem positiven Anschluss der Ansteuerleistungsversorgung, dem negativen Anschluss der Ansteuerleistungsversorgung, der negativen Elektrode der ersten Halbleiterschaltvorrichtung und der Steuerelektrode der ersten Halbleiterschaltvorrichtung verbunden und ausgelegt ist, um die Ansteuerspannung an die Steuerelektrode der ersten Halbleiterschaltvorrichtung auszugeben; und
ein Impedanzelement (11, 21), das in einem geschlossenen Stromkreis angeordnet ist, durch den der Ansteuerstrom fließt, und das bewirkt, dass sich die Induktivität des geschlossenen Stromkreises erhöht, wobei der geschlossene Stromkreis den positiven Anschluss der Ansteuerleistungsversorgung, die Steuerelektrode der ersten Halbleiterschaltvorrichtung, die negative Elektrode der ersten Halbleiterschaltvorrichtung und den negativen Anschluss der Ansteuerleistungsversorgung umfasst,
**dadurch gekennzeichnet, dass**
das Impedanzelement (11, 21) angepasst ist, um die Resonanzfrequenz eines Resonanzstromkreises in Richtung einer Niedrigfrequenzseite zu verändern, wobei der Resonanzstromkreis die Induktivität des geschlossenen Stromkreises und eine Streukapazität zwischen der Steuerelektrode und der negativen Elektrode der ersten Halbleiterschaltvorrichtung umfasst,
wobei das Impedanzelement (11, 21) eine Charakteristik aufweist, sodass eine Widerstandskomponente mit Ansteigen einer Frequenz zunimmt.

2. Leistungswandler nach Anspruch 1, wobei
die Ansteuerschaltung (38, 138) mit einem Referenzpotentialverbindungspunkt (8) verbunden ist, mit dem der negative Anschluss der Ansteuerleistungsversorgung und die negative Elektrode der ersten Halbleiterschaltvorrichtung verbunden sind, und
das Impedanzelement (11, 21) zwischen der negativen Elektrode der ersten Halbleiterschaltvorrichtung (134, 34, 35, 36) und dem Referenzpotentialverbindungspunkt angeordnet ist.

3. Leistungswandler nach Anspruch 2, Folgendes umfassend:
einen Negativanschlussverbindungspunkt (102), der mit einem negativen Anschluss einer GS-Leistungsversorgung (6) verbunden ist, die zur Versorgung mit Hauptstromkreisstrom ausgelegt ist;
eine gemeinsame Leitung (106), die mit der negativen Elektrode der ersten Halbleiterschaltvorrichtung (34, 35, 36) verbunden ist, wobei der Hauptstromkreisstrom und der Ansteuerstrom durch die gemeinsame Leitung fließen;
eine Hauptstromkreisleitung (105), die die gemeinsame Leitung mit dem Negativanschlussverbindungspunkt verbindet, wobei der Hauptstromkreisstrom durch die Hauptstromkreisleitung fließt; und
eine Ansteuerschaltungsleitung (104), die die gemeinsame Leitung mit dem Referenzpotentialverbindungspunkt (8) verbindet, wobei der Ansteuerstrom durch die Ansteuerschaltungsleitung fließt, wobei
das Impedanzelement (11) in der Ansteuerschaltungsleitung angeordnet ist.

4. Leistungswandler nach einem der Ansprüche 1 bis 3, wobei
die Ansteuerschaltung (38) einen Gate-Widerstand (84, 85, 86) aufweist, der mit der Steuerelektrode der ersten Halbleiterschaltvorrichtung (34, 35, 36) verbunden ist, und
das Impedanzelement (11) separat vom Gate-Widerstand bereitgestellt ist.

5. Leistungswandler nach einem der Ansprüche 1 bis 4, wobei die erste Halbleiterschaltvorrichtung aus einer Vielzahl von ersten Halbleiterschaltvorrichtungen (34, 35, 36) besteht, die miteinander parallel geschaltet sind, wobei jede der Vielzahl von ersten Halbleiterschaltvorrichtungen die positive Elektrode, die negative Elektrode und die Steuerelektrode aufweist.

6. Leistungswandler nach Anspruch 5, wobei die Vielzahl von ersten Halbleiterschaltvorrichtungen (34, 35, 36) eine Zeitspanne aufweist, während der alle aus der Vielzahl von ersten Halbleiterschaltvorrichtungen EINgeschaltet sind.

7. Leistungswandler nach Anspruch 5 oder 6, umfassend einen Negativelektrodenverbindungspunkt (102), mit dem alle negativen Elektroden der Vielzahl von ersten Halbleiterschaltvorrichtungen (34, 35, 36) verbunden sind, wobei das Impedanzelement (11) zwischen den Negativelektrodenverbindungspunkt und den Referenzpotentialverbindungspunkt (8) geschaltet ist.

8. Leistungswandler nach einem der Ansprüche 1 bis 7, ferner umfassend eine zweite Halbleiterschaltvorrichtung (131, 31, 32, 33), die mit der positiven Elektrode der ersten Halbleiterschaltvorrichtung (134, 34, 35, 36) in Serie geschaltet ist.

9. Leistungswandler nach Anspruch 8, wobei die zweite Halbleiterschaltvorrichtung aus einer Vielzahl von zweiten Halbleiterschaltvorrichtungen (31, 32, 33) besteht, die miteinander parallel geschaltet sind.

10. Leistungswandler nach einem der Ansprüche 1 bis 9, umfassend einen Stromdetektor (18, 28), der mit der negativen Elektrode der ersten Halbleiterschaltvorrichtung (134, 34, 35, 36) verbunden ist, wobei
die Ansteuerschaltung (138, 38) die Ausgabe der Ansteuerspannung basierend auf dem Ergebnis einer Detektion durch den Stromdetektor steuert.

11. Leistungswandler nach einem der Ansprüche 1 bis 10, wobei
die erste Halbleiterschaltvorrichtung (31, 32, 33, 34) in einem Leistungsmodul (10) angeordnet ist, und
das Impedanzelement (11, 21) außerhalb des Leistungsmoduls angeordnet ist.

12. Leistungswandler nach einem der Ansprüche 1 bis 11, wobei
das Impedanzelement (11, 21) eine Induktivität aufweist, die so eingestellt ist, dass die Resonanzfrequenz 1/2 oder weniger einer durch die Streukapazität bestimmten Resonanzfrequenz und der Induktivität des geschlossenen Stromkreises ohne das Impedanzelement entspricht.

13. Leistungswandler nach einem der Ansprüche 1 bis 12, wobei das Impedanzelement (11, 21) ein Induktor mit einem Kern ist.

14. Leistungswandler nach einem der Ansprüche 1 bis 13, wobei die erste Halbleiterschaltvorrichtung (134, 34, 35, 36) ein aus einem Siliciumcarbid-Halbleitermaterial ausgebildeter MOSFET ist.

## Revendications

1. Convertisseur de puissance, comprenant :
un premier dispositif de commutation à semi-conducteur (134, 34, 35, 36) ayant une électrode positive, une électrode négative et une électrode de commande à laquelle une tension d'entraînement par rapport à l'électrode négative en tant que référence est appliquée ;
une alimentation électrique d'entraînement (15) ayant une borne positive et une borne négative et configurée pour fournir, à l'électrode de commande, un courant d'entraînement pour mettre en marche le premier dispositif de commutation à semi-conducteur ;
un circuit d'entraînement (138, 38) connecté à la borne positive de l'alimentation d'entraînement, à la borne négative de l'alimentation d'entraînement, à l'électrode négative du premier dispositif de commutation à semi-conducteur, et à l'électrode de commande du premier dispositif de commutation à semi-conducteur, et configuré pour délivrer en sortie la tension d'entraînement à l'électrode de commande du premier dispositif de commutation à semi-conducteur ; et
un élément d'impédance (11, 21) disposé dans un circuit fermé à travers lequel le courant d'entraînement circule et amenant une inductance du circuit fermé à augmenter, le circuit fermé comprenant la borne positive de l'alimentation électrique d'entraînement, l'électrode de commande du premier dispositif de commutation à semi-conducteur, l'électrode négative du premier dispositif de commutation à semi-conducteur, et la borne négative de l'alimentation électrique d'entraînement,
**caractérisé en ce que**
l'élément d'impédance (11, 21) est adapté pour changer une fréquence de résonance d'un circuit de résonance vers un côté basse fréquence, le circuit de résonance comprenant l'inductance du circuit fermé et une capacité parasite entre l'électrode de commande et l'électrode négative du premier dispositif de commutation à semi-conducteur,
dans lequel l'élément d'impédance (11, 21) a une caractéristique telle qu'une composante de résistance augmente avec l'augmentation d'une fréquence.

2. Convertisseur de puissance selon la revendication 1, dans lequel
le circuit d'entraînement (38, 138) est connecté à un point de connexion de potentiel de référence (8) auquel la borne négative de l'alimentation d'entraînement et l'électrode négative du premier dispositif de commutation à semi-conducteur sont connectées, et
l'élément d'impédance (11, 21) est disposé entre l'électrode négative du premier dispositif de commutation à semi-conducteur (134, 34, 35, 36) et le point de connexion de potentiel de référence.

3. Convertisseur de puissance selon la revendication 2, comprenant :
un point de connexion de borne négative (102) connecté à une borne négative d'une alimentation en courant continu (6) configurée pour fournir un courant de circuit principal ;
une ligne commune (106) connectée à l'électrode négative du premier dispositif de commutation à semi-conducteur (34, 35, 36), le courant de circuit principal et le courant d'entraînement circulant à travers la ligne commune ;
une ligne de circuit principal (105) reliant la ligne commune au point de connexion de borne négative, le courant de circuit principal circulant à travers la ligne de circuit principal ; et
une ligne de circuit d'entraînement (104) connectant la ligne commune au point de connexion de potentiel de référence (8), le courant de commande circulant à travers la ligne de circuit d'entraînement, dans lequel
l'élément d'impédance (11) est disposé dans la ligne de circuit d'entraînement.

4. Convertisseur de puissance selon l'une quelconque des revendications 1 à 3, dans lequel
le circuit d'entraînement (38) a une résistance de grille (84, 85, 86) connectée à l'électrode de commande du premier dispositif de commutation à semi-conducteur (34, 35, 36), et
l'élément d'impédance (11) est prévu séparément de la résistance de grille.

5. Convertisseur de puissance selon l'une quelconque des revendications 1 à 4, dans lequel le premier dispositif de commutation à semi-conducteur est constitué d'une pluralité de premiers dispositifs de commutation à semi-conducteur (34, 35, 36) connectés en parallèle les uns aux autres, chacun de la pluralité de premiers dispositifs de commutation à semi-conducteur ayant l'électrode positive, l'électrode négative et l'électrode de commande.

6. Convertisseur de puissance selon la revendication 5, dans lequel la pluralité de premiers dispositifs de commutation à semiconducteur (34, 35, 36) ont une période pendant laquelle la totalité de la pluralité de premiers dispositifs de commutation à semiconducteur sont en marche.

7. Convertisseur de puissance selon la revendication 5 ou 6, comprenant un point de connexion d'électrode négative (102) auquel toutes les électrodes négatives de la pluralité de premiers dispositifs de commutation à semi-conducteur (34, 35, 36) sont connectées, dans lequel
l'élément d'impédance (11) est monté entre le point de connexion d'électrode négative et le point de connexion de potentiel de référence (8).

8. Convertisseur de puissance selon l'une quelconque des revendications 1 à 7, comprenant en outre un second dispositif de commutation à semi-conducteur (131, 31, 32, 33) connecté en série à l'électrode positive du premier dispositif de commutation à semi-conducteur (134, 34, 35, 36) .

9. Convertisseur de puissance selon la revendication 8, dans lequel le second dispositif de commutation à semi-conducteur est constitué d'une pluralité des seconds dispositifs de commutation à semi-conducteur (31, 32, 33) connectés en parallèle les uns aux autres.

10. Convertisseur de puissance selon l'une quelconque des revendications 1 à 9, comprenant un détecteur de courant (18, 28) connecté à l'électrode négative du premier dispositif de commutation à semi-conducteur (134, 34, 35, 36), dans lequel
le circuit d'entraînement (138, 38) commande la sortie de la tension d'entraînement sur la base d'un résultat de détection par le détecteur de courant.

11. Convertisseur de puissance selon l'une quelconque des revendications 1 à 10, dans lequel
le premier dispositif de commutation à semi-conducteur (31, 32, 33, 34) est disposé à l'intérieur d'un module de puissance (10), et
l'élément d'impédance (11, 21) est disposé à l'extérieur du module de puissance.

12. Convertisseur de puissance selon l'une quelconque des revendications 1 à 11, dans lequel
l'élément d'impédance (11, 21) a une inductance qui est réglée de telle sorte que la fréquence de résonance est égale ou inférieure à la moitié d'une fréquence de résonance déterminée par la capacité parasite et une inductance du circuit fermé sans l'élément d'impédance.

13. Convertisseur de puissance selon l'une quelconque des revendications 1 à 12, dans lequel l'élément d'impédance (11, 21) est une inductance ayant un noyau.

14. Convertisseur de puissance selon l'une quelconque des revendications 1 à 13, dans lequel le premier dispositif de commutation à semi-conducteur (134, 34, 35, 36) est un MOSFET formé à partir d'un matériau semi-conducteur de carbure de silicium.
